# EUROPEAN PATENT SPECIFICATION

(11) **EP 4 281 513 B1**
(45) Date of publication and mention of the grant of the patent: **06.08.2025**
(21) Application number: 22701938.7
(22) Date of filing: 21.01.2022
(51) Int. Cl.: C09K 11/02, C09K 11/66

(54) **LIGAND-SUPPORTED PEROVSKITE LUMINESCENT CRYSTAL COMPOSITION AND METHOD FOR PRODUCING THE SAME**
LIGANDEN-GESTÜTZTE PEROWSKIT-LUMINESZIERENDE KRISTALLZUSAMMENSETZUNG UND VERFAHREN ZU DEREN HERSTELLUNG
COMPOSITION DE CRISTAUX LUMINESCENTS DE PÉROVSKITE À BASE DE LIGANDS ET SON PROCÉDÉ DE PRODUCTION

(30) Priority: 21.01.2021 EP 21152825
(43) Date of publication of application: 29.11.2023
(73) Proprietor: Universität für Bodenkultur Wien, 1180 Wien (AT)
(72) Inventor: SHIRMARDI, Behzad, 1190 Wien (AT); REIMHULT, Erik, 1190 Wien (AT)
(74) Representative: SONN Patentanwälte GmbH & Co KG
(86) International application number: PCT/EP2022/051292
(87) International publication number: WO 2022/157279

(56) References cited:
- US-A1- 2019 218 108
- US-A1- 2020 255 724
- KIM HYUNKI ET AL: "Nanocomposites Hot Paper Polymer Zwitterions for Stabilization of CsPbBr 3 Perovskite Nanoparticles and Nanocomposite Films", ANGEW. CHEM. INT. ED., vol. 59, 5 March 2020 (2020-03-05), pages 10802 - 10806, XP055812066, DOI: doi.org/10.1002/anie.201916492
- BARANOV DMITRY ET AL: "Transforming colloidal Cs 4 PbBr 6 nanocrystals with poly(maleic anhydride- alt -1-octadecene) into stable CsPbBr 3 perovskite emitters through intermediate heterostructures", CHEMICAL SCIENCE, vol. 11, no. 15, 20 March 2020 (2020-03-20), United Kingdom, pages 3986 - 3995, XP055812070, ISSN: 2041-6520, DOI: 10.1039/D0SC00738B

## Description

The present invention relates to the field of perovskite luminescent crystal formation and their ligand-supported stabilization and embedding into a polymer matrix.

### Background of the Invention

Perovskites possess unique optoelectronic and crystallographic properties. Due to their high performance, low cost and abundance, perovskites are a very promising material class for a wide range of applications, such as solar cells, lasers, light-emitting diodes (LEDs), water splitting and laser cooling (Ha et al., Chem. Sci. 2017, 8, 2522-2536). The use of perovskite quantum dots (PQDs) or perovskite nanocrystals that show luminescence (so-called perovskite luminescent crystals) further enhances the photoluminescence quantum yield (PLQY). The radiative recombination is promoted by the confinement of holes and electrons, especially in quantum dots (QDs), as the physical diameter of QDs is smaller than the Bohr radius, causing the quantum confinement effect to predominate (Cha et al., J. Mater. Chem. C, 2017, 5, 6667-6671).

Protesescu et al. (Nano Lett. 2015, 15, 3692-3696) disclose perovskite nanocrystals as optoelectronic materials with bright emission and wide color gamut.

Pathak et al. (Chem. Mater. 2015, 27, 8066-8075) describe perovskite nanocrystals for tunable white light emission.

However, their ionic nature renders perovskites extremely sensitive to external stress, e.g. polar solvents, heat, oxygen, moisture, light or electric fields (Wang et al., Adv. Mater. 2016, 28, 10710-10717). Several passivation strategies have been developed to enhance the stability of perovskites, such as (i) film formation through impregnation and pore filling of a pre-formed mesoporous inorganic matrix, (ii) macroscale passivation by coverage of perovskite films with polymer or carbon nanotube (CNT) composites, or (iii) passivation of individual nanocrystal grains. However, these strategies often lead to insufficient protection or reduced light-emitting efficiency of perovskite luminescent crystals (Wang et al., Adv. Mater. 2016, 28, 10710-10717).

The encapsulation of luminescent crystals in an organic matrix to improve their stability to external stress is commonly applied in the state of the art. Especially QDs are widely used in quantum dot light-emitting diode (QLED) TVs due to their pure and saturated emission colors with narrow bandwidth, low processing cost and easy tuning of their emission wavelength by changing the size of the QDs. The QDs are incorporated in a color-generating quantum dot enhancement film (QDEF) and convert the light emitted from a blue LED backlight to pure and saturated red and green light. The combination of these three primary colors enables the generation of any color on the pixel level with high energy efficiency.

The use of perovskite quantum dots (PQDs) in QDEF has several advantages over previous-generation QDs based on cadmium or indium, namely (i) lower cost of production, (ii) lower toxicity and (iii) superior color saturation. However, the above-described susceptibility of PQDs to degradation needs to be satisfactorily overcome to enable their use in color-generating films.

Cha et al. (J. Mater. Chem. C, 2017, 5, 6667) describe the formation of size-controllable organometallic halide PQDs in a polymer film comprising patterning the film, removing patterning particles by etching and growing the perovskite QDs in the etched pores of the polymer film.

Lin et al. (ACS Appl. Mater. Interfaces, DOI: 10.1021/acsami.7b15989) describe water-resistant stretchable perovskite-embedded fiber membranes for LEDs.

Pan et al. (Nano Lett. 2017, 17, 11, 6759-6765) describe ternary graphene oxide-polymer-perovskite nanocrystal composites with high environmental stability.

Raja et al. (ACS Appl. Mater. Interfaces 2016, 8, 35523-35533) disclose encapsulation of perovskite nanocrystals into macroscale polymer matrices for stability.

Wang et al. (Adv. Mater. 2016, 28, 10710-10717) and WO 2018/009530 A1 investigate stability improvements of organic-inorganic perovskite-polymer composite films by means of swelling and deswelling of the polymer. The use of the polymers polystyrene (PS), polycarbonate (PC), acrylonitrile butadiene styrene (ABS), cellulose acetate (CA), polyvinyl chloride (PVC), and poly(methyl methacrylate) (PMMA) is described.

WO 2019/177537 A1 describes perovskite-containing polymeric films wherein the polymeric matrix is formed from monomers comprising vinyl groups.

US 6,716,927 describes laminar perovskite compounds, wherein the perovskite is integrated in an organic compound (e.g. (CH₃(CH₂)₂C≡CC≡CCH₂-NH₃)₂PbBr₄).

US 9,905,765 B2 and US 2018/0159041 A1 describe polymer-perovskite films, wherein the perovskite is a methylammonium lead chloride (CH₃NH₃PbCl₃) nanopillar crystal. A suitable polymer for these nanopillars is polyimide.

EP 3296378 A1 describes perovskite-polymer composites, wherein the perovskite is of the formula CsAB₃ or comprises an organic part according to its formula R₁NH₃AB₃, and with the polymer being any one of polyvinylidene fluoride (PVDF), polyvinyl acetate (PVAc), cellulose acetate (CA), polysulfone (PSF), aromatic polyamide (PA), polyimide (PI), polycarbonate (PC), polystyrene (PS).

Lead-free metal halide perovskites in a polymer matrix for X-ray absorption are described in WO 2019/195517 A1.

The color spectrum of perovskite luminescent crystals can be altered by anion exchange, such as described in Nedelcu et al. (Nano Lett. 2015, 15, 8, 5635-5640), Wong et al. (Adv. Mater. 2019, 1901247), Torun et al. (ACS Appl. Nano Mater. 2019, 2, 3, 1185-1193), Akkerman et al. (J. Am. Chem. Soc. 2015, 137, 32, 10276-10281), Zhang et al. (J. Am. Chem. Soc. 2016, 138, 23, 7236-7239) and Guhrenz et al. (Chem. Mater. 2016, 28, 24, 9033-9040). However, when encapsulating perovskite luminescent crystals that emit different colors in the same polymer matrix, a strong ion-exchange effect is observed which widens the narrow emission spectrum, thus leading to decreased purity and color saturation (Wang et al., Angew. Chem. Int. 2016, 55, 7924-7929).

A common method to avoid ion-exchange is the use of a color-generating layer made of several sublayers, e.g. in US 2019/0018287 A1. As each perovskite luminescent crystal composition is embedded in a separate sub-layer, pure and saturated colors are generated. However, the manufacture of separate layers for the generation of different colors significantly increases the complexity and production costs.

Another method to avoid ion-exchanges involves the coating of perovskite luminescent crystals with high-affinity ligands (also referred to as surfactants or dispersants) that tightly bind to their surface. Such ligands not only allow the preservation of distinct emission spectra of perovskite luminescent crystals with a different composition when being mixed and embedded in the same polymer matrix, but brings additional benefits regarding the stability of the perovskite luminescent crystals.

The coating process can either by carried out during the synthesis of the luminescent crystals or by means of a post-synthetic encapsulation process. The coating with inorganic compounds (e.g. SiO₂, TiO₂, Al₂O₃, PbS, graphene oxide, etc.) and polymers (e.g. polystyrene (PS), poly(methyl methacrylate) (PMMA), ethylene vinyl acetate copolymer (EVA), poly(ethylene glycol) (PEG)) is known to enhance the stability of perovskite luminescent crystals (Liu et al., Nano Lett. 2019, 19, 9019-9028).

The coating of perovskite luminescent crystals with an oxide coating is disclosed in US 2019/ 0148602 A1. The oxide is selected from silica, alumina, titanium, boron oxide and zinc oxide.

Huang et al. (Chem. Sci., 2016, 7, 5699-5703) describe the production of water-resistant CsPbX₃ nanocrystals coated with a polyhedral oligomeric silsesquioxane (POSS) and their use in LEDs.

Kim et al. (Angew. Chem. Int. Ed. 2020, 59, 10802-10806) disclose polymer films with good perovskite nanoparticle dispersion and optical transparency, which comprise functional polymers with sulfobetaine or phosphorylcholine zwitterions both as ligands and matrices.

US 2019/0153313 A1 discloses a solid polymer composition comprising perovskite crystals, a non-ionic, anionic, cationic or zwitter-ionic surfactant and a cured polymer selected from the group of acrylate polymers, styrene polymers, silicone polymers, carbonate polymers and cyclic olefin polymers.

US 2019/218108 A1 describes fluorescent compounds having a given structure formula, bound to a plurality of NH₃⁺ group containing ions and a plurality of COO⁻ group containing ions.

Baranov et al. (Chemical Science, 2020, 11 (5), 3986-3995) relates to CsPbBr₃ nanocrystals comprising polysuccinamic acid ligands.

### Summary of the invention

It is an object of the present invention to provide a perovskite luminescent crystal composition bearing a polymeric surface ligand, thereby forming a perovskite luminescent crystal-ligand complex with excellent stability and excellent brightness.

It is a further object of the present invention to provide a method for manufacturing said perovskite luminescent crystal composition and embed it in a polymer matrix.

It was surprisingly found that perovskite luminescent crystals bearing a multidentate polymeric surface ligand, i.e. a polymeric surface ligand comprising more than one functional group, have enhanced stability and emit pure and saturated colors with excellent brightness.

It was further surprisingly found that perovskite luminescent crystals bearing a polysiloxane comprising primary amine groups as multidentate polymeric surface ligand show (i) a particularly high brightness, as reflected in a photoluminescence quantum yield (PLQY) of at least 90% or above, and a full width half maximum (FWHM) of 20 nm or below, which signifies high purity and saturation of the emitted color, and (ii) an excellent stability and aging resistance.

It was further surprisingly found that the inventive perovskite luminescent crystals bearing a polymeric surface ligand according to the present invention can be embedded in any desired polymer with an excellent dispersion and homogeneity when tailoring the processing parameters accordingly.

It was further surprisingly found that the inventive perovskite luminescent crystals bearing a polymeric surface ligand according to the present invention is particularly suitable to be embedded in polystyrene (PS), in poly(methyl methacrylate) (PMMA), in an in situ crosslinked polydimethylsiloxane (PDMS) or in an in situ crosslinked UV curable resin with a particularly excellent dispersion and homogeneity.

The present invention provides a perovskite luminescent crystal composition and a method for manufacturing the same. In particular, the present invention is directed to a perovskite luminescent crystal composition comprising perovskite luminescent crystals bearing a polymeric surface ligand with a molecular weight of at least 700 g/mol, preferably at least 2,000 g/mol, particularly preferably at least 3,000 g/mol, wherein the polymeric surface ligand is a polysiloxane comprising a backbone and side chains, wherein at least one side chain comprises at least one functional group selected from amines, carboxylates, phosphates, thiols or combinations thereof, preferably primary amines, wherein the binding of the perovskite luminescent crystals to the surface ligand occurs through the surface ligand's functional groups, thereby forming a perovskite luminescent crystal-ligand complex.

The present invention is further directed to a method of generating a perovskite luminescent crystal composition comprising providing perovskite luminescent crystals and providing a polymeric surface ligand having a molecular weight of at least 700 g/mol, preferably at least 2,000 g/mol, particularly preferably at least 3,000 g/mol, wherein the polymeric surface ligand is a polysiloxane comprising a backbone and side chains, wherein at least one side chain comprises at least one functional group selected from amines, carboxylates, phosphates, thiols or combinations thereof, preferably primary amines, and mixing said perovskite luminescent crystals with the polymeric surface ligand and/or crystallizing the perovskite luminescent crystals in the presence of the polymeric surface ligand, thereby forming a perovskite luminescent crystal-surface ligand complex.

The present invention will be described in detail below. All preferred embodiments of this invention are interrelated, and each preferred embodiment and/or disclosed characteristic feature may be combined with each other and also as any combination of two or more preferred embodiments/characteristic features.

### Detailed description of the invention

Within the context of the present application, the inventive perovskite luminescent crystal composition comprising perovskite luminescent crystals and a polymeric surface ligand is also referred to as "perovskite luminescent crystal-ligand complex" or as "particle composition". The "perovskite luminescent crystals and a polymeric surface ligand" are also referred to as "particles".

The terms "a", "an," "the" and similar terms used in the context of the present invention are to be construed to cover both the singular and plural unless otherwise indicated herein or clearly contradicted by the context.

Unless stated otherwise, the following definitions apply in the context of the present application.

The term **"luminescent crystals" (LCs)** relates to particles comprising quantum dots (QDs) and/or (nano-)crystals in the form of single crystals and polycrystalline particles that show luminescence and have sizes in the range of 2 nm to 200 µm. In the case of polycrystalline particles, one crystal may be composed of several crystal domains (grains), connected by crystalline or amorphous phase boundaries. In this context, the term "crystalline" refers to the long-range ordering of nanostructures across one or more structural dimensions that luminescent crystals typically exhibit. Luminescence of the inventive particles and compositions preferably signifies photoluminescence.

The term **"precursor"** according to the present invention is a precursor of a perovskite luminescent crystal and comprises a monovalent cation (A), a divalent cation (M), an anion (X) and a guest molecule. The precursor may be amorphous, crystalline, or a mixture of an amorphous and a crystalline phase.

**"Quantum dots" (QDs)** are a sub-group of luminescent crystals and have a diameter typically in the range of 2 nm to 15 nm. In this range, the physical diameter of the QDs is in the range of the exciton Bohr radius, causing the quantum confinement effect to predominate. As a result, the electronic states of the QDs, and therefore the bandgap, are a function of the QD composition and physical size, i.e. the color of absorption/emission is linked to the QD size. The optical quality of the QD sample is directly linked to their homogeneity, with a higher monodispersity corresponding to a smaller full width half maximum (FWHM).

The term **"full width half maximum" (FWHM)** signifies the difference between the two values of the independent variable at which the dependent variable in a distribution is equal to half of its maximum value. That is, the FWHM is the width of a spectrum curve measured between those points on the y-axis which are half the maximum amplitude. In terms of the emission spectrum of a luminescent crystal, the FWHM depends on both their size and chemical structure. The smaller the FWHM, the higher is the purity and saturation of the emitted light/color.

The **"photoluminescence quantum yield" (PLQY)** signifies the brightness of luminescent crystals and is calculated as the ratio of the number of emitted photons to the number of absorbed photons.

The term **"luminescent crystal (LC) composite"** relates to a composite material comprising luminescent crystals and a matrix. In LC composites, luminescent crystals are embedded in a matrix, such as a polymer matrix or an inorganic matrix, which spatially separates the luminescent crystals from one another and stabilizes them by protecting them from external stresses such as oxygen and humidity.

The term **"matrix"** refers to the continuous phase of a composite material, such as a polymer matrix or an inorganic matrix, with a discontinuous phase being embedded therein. Within the context of the present invention, the term "matrix" signifies a polymer matrix. The discontinuous phase embedded in a matrix preferably has a reinforcing or property-enhancing effect and may be selected from (nano-)particles, fibers, filaments, textiles. In the present application, the discontinuous phase is the inventive perovskite luminescence crystal composition comprising perovskite luminescent crystals bearing a polymeric surface ligand.

The term **"polymer"** refers to macromolecules that comprise a large number of covalently linked repeating units. This term comprises the groups of synthetic polymers and natural polymers, and thermoplastics, thermosets (also referred to as thermosetting resins) and elastomers. Thermoplastics are either amorphous or semi-crystalline polymers and comprise linear polymer chains with or without branches, i.e. with or without the presence of side chains. Thermosets and elastomers are three-dimensionally crosslinked polymers. Within the scope of the present application, the term polymer comprises homopolymers, copolymers and terpolymers likewise. Polymers comprise a **"backbone"** or also termed "backbone chain", which is the longest series of covalently bonded atoms that together create the continuous chain of the molecule. The backbone contains repeating subunits stemming from similar monomer moieties that are linked during the polymerization process. Atoms between two polymerizing groups in a monomer become part of the backbone, when joined in the longest series of covalently bonded atoms (i.e. in the main chain, as apart from side chains).

The term **"pre-polymer"** is understood to comprise monomers and oligomers. Monomers are molecules which can undergo polymerization and thereby contribute as constitutional units to the structure of a macromolecule. An oligomer typically comprises between about four and a hundred repeating units formed by chemically binding together many identical or similar monomer units.

The terms **"cure"/"curing", "crosslink"/"crosslinking", "harden"/"hardening"** are interchangeably used within the scope of the present invention. These terms define the formation of covalent bonds to generate a three-dimensional polymer network by forming covalent bonds between linear polymer chains (i.e. thermoplastics) or between multifunctional pre-polymers. Crosslinking may be carried out for example upon heating or by means of radiation, for example with UV light, gamma rays or X-rays, preferably in the presence of a hardener (also referred to as crosslinker, curative or curing agent) and/or a (photo-)initiator.

The term **"solvent"** relates to liquid molecules that are capable of dissolving materials such as substances or compounds. Solvents may be selected from the groups of inorganic or organic molecules, saturated or unsaturated molecules, polar or non-polar molecules, and linear, branched or cyclic molecules. Organic solvents typically have 2 to 24 carbon atoms, preferably 4 to 16 carbon atoms. Within the scope of the present application, the term solvent particularly refers to organic solvents.

The term **"ligand"** denotes organic molecules other than a solvent which are used to improve the separation of particles, such as luminescent crystals, in suspension or colloids and to prevent agglomeration or settling of these particles. Apart from the term "ligand", the terms "surfactant", "dispersing agent" or "dispersant" are synonymously used. Ligands are physically or chemically attached to the particle surface, e.g. via covalent, ionic, van der Waals or other molecular interactions. Ligands are bound to the particle surface either before or after adding the particles to the solvent, thereby providing the desired improvement of particle separation. Ligands may be selected from the groups of polymers, oligomers and monomers and may comprise polar and/or non-polar functional groups in the backbone, the side chains or as end groups. Within the scope of the present application, a "multidentate polymeric surface ligand" signifies a polymer comprising more than one functional group.

The term **"suspension"** signifies a heterogeneous mixture in which solid particles do not dissolve but get suspended throughout the bulk of the solvent and float around freely. The solid particles are dispersed throughout the solvent/fluid by means of mechanical agitation.

The present invention relates to a perovskite luminescent crystal composition comprising perovskite luminescent crystals that are bound by a polymeric surface ligand. The perovskite crystals are bound by a polymeric surface ligand having a molecular weight of at least 700 g/mol, wherein the polymeric surface ligand is a polymer, namely a polysiloxane, comprising a backbone and side chains, wherein at least one side chain comprises at least one functional group selected from amine groups, carboxylate groups, phosphate groups, thiolate groups or combinations thereof, wherein the binding of the perovskite luminescent crystals to the surface ligand occurs through the surface ligand's functional groups, thereby forming a perovskite luminescence crystal-ligand complex. The ligand may comprise only one type or alternatively a combination of the functional groups. A combination is e.g. given in zwitterionic ligands that comprise anionic (e.g. carboxylate, phosphate) and cationic (e.g. amine as ammonium) functional groups. The amine may be a primary, secondary or tertiary amine. The amine may be charged or not charged.

The perovskite luminescence crystals are preferably selected from compounds with the formula AₐM_{b}X_{c},
wherein
A represents one or more monovalent cations selected from Cs⁺, Rb⁺, K⁺, Na⁺, Li⁺, ammonium, methylammonium, formamidinium, strontium, guanidinium, imidazolium, pyridinium, pyrrolidinium, protonated thiourea, or a mixture thereof;
M represents one or more metals selected from the group comprising Pb²⁺, Ge²⁺, Sb²⁺, Te²⁺, Sn²⁺, Bi²⁺, Mn²⁺, Cu²⁺, and any rare earth ions, preferably Ce²⁺, Tb²⁺, Eu²⁺, Sm²⁺, Yb²⁺, Dy²⁺, Tm²⁺; and Ag⁺ or Au⁺ or a mixture thereof;
X represents one or more anions selected from the group comprising F⁻, Cl⁻, Br⁻, I⁻, cyanide, thiocyanate, or a mixture thereof;
a is an integer from 1 to 4, such as 1, 2, 3, 4;
b is an integer of 1 or 2;
c is an integer from 3 to 9, such as 3, 4, 5, 6, 7, 8, 9.

Preferably the perovskite luminescent crystals are of formula AMX₃, formula A₄MX₆ or mixtures thereof, with A, M, X having the above meanings.

Preferably, inorganic perovskite luminescent crystals, particularly preferably with the formula CsPbBr₃, are used.

The perovskite luminescent crystals of the inventive composition may have an average size along their longest dimension of 2 nm to 200 µm, preferably 5 nm to 50 nm, as measured by means of transmission electron microscopy (TEM). The quantum confinement effect is predominant and highly effective in this range of particle size, thus, together with the chemical structure of the inventive perovskite luminescent crystal composition, allowing for an excellent photoluminescence quantum yield.

The polymeric surface ligand according to the present invention comprises a backbone with backbone atoms selected from C, O, N, Si, S and side chains. Preferably, at least 0.0025 mol.-% of side chains of the polymeric surface ligand comprise one or more of the functional groups selected from amines, carboxylates, phosphates, thiols or combinations thereof; or the side chains of the polymeric surface ligand comprise at least one of these functional groups for every 800 backbone atoms of the polymeric surface ligand. Particularly preferably, the polymeric surface ligand comprises 0.5% to 25% functional groups, more preferably amine groups, most preferably primary amines groups, as these groups provide the perovskite luminescent crystals with a particularly high stability.

The polymeric surface ligand has a molecular weight in the range of 700 g/mol to 400,000 g/mol, preferably 900 g/mol to 400,000 g/mol, more preferably 1,100 g/mol to 400,000 g/mol, more preferably 1,300 g/mol to 400,000 g/mol, yet more preferably 1,600 g/mol to 400,000 g/mol, yet more preferably 2,000 g/mol to 400,000 g/mol, still more preferably 2,500 g/mol to 400,000 g/mol, still more preferably 3,000 g/mol to 400,000 g/mol, still more preferably 2,000 g/mol to 20,000 g/mol, most preferably 3,000 g/mol to 20,000 g/mol. Within this range of molecular weight, the polymeric surface ligand was surprisingly found to have a comparably long residence time onto the perovskite luminescent crystals and provides them with an excellent stability.

Preferably, the polymeric surface ligand is a viscous fluid with a viscosity of 10 to 100,000 cSt, more preferably 50 to 10,000 cSt, at a temperature of 23°C. This enables a ready dissolution in a suitable solvent and facilitates the processing.

The polymeric surface ligand may present in a layer around the perovskite luminescent crystals with an average thickness of 1 nm to 100 nm. This thickness ensures an excellent protection and stability of the perovskite luminescent crystals and a long residence time onto the particle surface whilst the photoluminescence quantum yield is not significantly impaired.

In a preferred embodiment, the backbone of the polymeric surface ligand comprises the structure of repeating subunits selected from -Si-O-, -C-O-, -C-C-, -C-C-O-, -Si-C-, -Si-C-O-, -Si-O-C-O-, C-S-, C-S-C-, -S-S-, -S-O-S-, -S-O-, wherein any C and or Si can be independently substituted.

Polysiloxanes are used as polymeric surface ligands in the present invention and may be selected from bis(3-aminopropyl) terminated poly(dimethylsiloxane), aminopropylmethylsiloxane-dimethylsiloxane copolymer, e.g. (2-3% aminopropylmethylsiloxane)-dimethylsiloxane copolymer, (4-5% aminopropylmethylsiloxane)-dimethylsiloxane copolymer, (6-7% aminopropylmethylsiloxane)-dimethylsiloxane copolymer, (9-11% aminopropylmethylsiloxane)-dimethylsiloxane copolymer, (20-25% aminopropylmethylsiloxane)-dimethylsiloxane copolymer, aminoethylaminopropyl-methoxysiloxane-dimethylsiloxane copolymer, e.g. (0.5-1.5% aminoethylaminopropyl-methoxysiloxane)-dimethylsiloxane copolymer with branch structure, (2-4% aminoethylaminopropyl-methoxysiloxane)-dimethylsiloxane copolymer with branch structure, or mixtures thereof.

The side chains of the polymeric surface ligand preferably comprise a functional group-containing structure -Z-L with Z being a branched, cyclic or linear C₁₋₃₀ alkyl, C₁₋₃₀ alkenyl, C₁₋₃₀ alkynyl, C₁₋₃₀ aryl, C₁₋₃₀ cycloalkyl, C₁₋₃₀ heteroalkyl, C₁₋₃₀ alkylamine, C₁₋₃₀ carboxyalkyl, wherein 1 or more C may be hetero-substituted by O, N, Si, S or P, and L being selected from the functional groups selected from amines, carboxylates, phosphates, thiols or combinations thereof. Preferably, at least every 100 repeating subunit comprises one functional group-containing structure. It is noted that polymeric surface ligands bearing only one functional group do not sufficiently protect perovskite luminescent crystals against degradation due to their facile desorption from the surface of the crystals. Contrary, polymeric surface ligands comprising more than one functional group (so-called multidentate polymeric surface ligands) have a longer residence time onto the surface of the perovskite luminescent crystals. If one of the functional groups detaches from the crystal surface, the polymeric surface ligand is still bound to the surface by the remaining functional groups.
Preferably, the polymeric surface ligand has the general formula 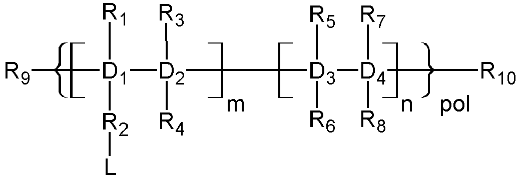 wherein
D₁ is selected from Si, C;
D₂ is absent or selected from Si, C, O, N, S;
D₃ is selected from Si, C, O, S;
D₄ is absent or selected from Si, C, O, N, S;
m is an integer from 0 to 2,000;
n is an integer from 0 to 2,000;
R₁, R₂, R₃, R₄, R₅, R₆, R₇, R₈ are independently selected from being absent, H, branched, cyclic or linear C₁₋₃₀ alkyl, C₁₋₃₀ alkenyl, C₁₋₃₀ alkynyl, being optionally O, S, N or P hetero substituted, preferably selected from methyl, ethyl, propyl, isopropyl, butyl, isobutyl, tert-butyl, vinyl, acryl, methacryl, ethyl aminopropyl, ethyl aminoethyl;
wherein R₃ and R₄ are absent when D₂ is absent, O, N or S;
wherein R₇ and R₈ are absent when D₄ is absent, O, N or S;
preferably, R₁, R₃, R₄, R₅, R₆, R₇ and R₈ are -CH₃; R₂ is preferably -CH₂- in the presence of L and -CH₃ in the absence of L;
L is absent or selected from the group of amines, carboxylates, phosphates, thiols, vinyls, vinyl siloxanes, alkoxysilyls, -Si(CH₃)₃, epoxides, carbinols, acrylates, saturated or unsaturated hydrocarbons, aromatic hydrocarbons, aliphatic hydrocarbons, cyclic or branched hydrocarbons, halogenated or non-halogenated hydrocarbons or a mixture thereof; preferably, L is absent or selected from C₁-, C₂-, C₃-, C₄-, C₅-, or C₆-alkyl amine, especially preferred -NH₂, -CH₂-NH₂, -CH₂-CH₂-NH₂, -CH₂-CH₂-CH₂-NH₂, -CH₂-CH₂-CH₂-NH₂-CH₂-CH₂-NH₂ or -O-CH₃. R₁, R₂, R₃, R₄, R₅, R₆, R₇, R₈ are preferably independently selected from C₁-, C₂-, C₃-, C₄-, C₅-, or C₆-alkyl.
R₉ and R₁₀ are absent or independently selected from the group of amines, carboxylates, phosphates, thiols or a mixture thereof;
wherein R₉ and R₁₀ are present, R₉ and L are present, R₁₀ and L are present, L is present, or R₉, R₁₀ and L are present;
preferably, R₉ and R₁₀ are selected from -CH₃, -NH₂, -CH₂-NH₂, -CH₂-CH₂-NH₂ or bis(3-aminopropyl), particularly preferably -CH₃.
pol is the degree of polymerization, preferably an integer of 3 to 1,000,000, preferably 4 to 5,401. For aminopropylmethylsiloxane-dimethylsiloxane copolymers, pol is preferably in the range of 8 to 84 which corresponds to a molecular weight of the polymeric surface ligand of 2,000 g/mol to 20,000 g/mol. In a preferred embodiment, D₁ is Si, D₂ is O, D₃ is Si and D₄ is O.

In a preferred embodiment, the polymeric surface ligand is a copolymer with the following subunits: 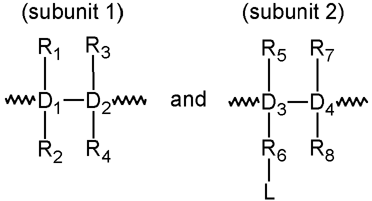 wherein D₁, D₂, D₃, D₄, R₁, R₂, R₃, R₄, R₅, R₆, R₇, R₈, L have the above meaning, and wherein the molecular ratio of subunit 2 to subunit 1 in the copolymer is 0.0025 to 1. Preferably, the side chains are anionic, cationic, non-ionic or zwitter-ionic. The subunits are connected at backbone atoms D₁, D₂, D₃, and D₄, if present. In a preferred embodiment, D₁ is Si, D₂ is O. Preferably, also D₃ is Si and D₄ is O. Polymeric surface ligand may comprise subunit 2, or a combination of subunit 1 and subunit 2. Different variations of subunits 1 and/or subunit 2 may be present, e.g. with different selections of D₁, D₂, D₃, D₄, R₁, R₂, R₃, R₄, R₅, R₆, R₇, R₈, L.

According to the present invention, a multitude of the perovskite luminescent crystals (LC) bearing polymeric surface ligands (referred to as particles) can be embedded in a polymer matrix, hereby generating so-called LC composites. The term "embedding" signifies that most of these particles are within and surrounded by the polymer matrix, but some particles may also be located at the edges and onto the surface of the polymer matrix.

In a preferred embodiment, the particles are embedded in a polymer, preferably an elastomer, as this material class provides a high flexibility and stretchability. The polymer is in a solid form, preferably with a thickness of 1 µm to 50 mm, particularly preferably 5 µm to 1 mm, which range is well suitable to enable the use of so-formed LC composite films in numerous applications such as QDEF in QLED TVs and scintillators.

The solid polymer is preferably devoid of -CH₂-OH, -CH₂-NH₂ or -CH₂-SH functional groups or comprises these functional groups in amounts of less than 1 functional group per 1,000 backbone atoms of the polymeric surface ligand. Preferably, the solid polymer is a polymer with a chemical structure of the backbone as defined for the polymeric surface ligand according to the present invention, but is devoid of the structural unit L, as defined above.

Particularly preferably, the solid polymer is a polymer selected from (i) the group of elastomers comprising silicone rubber (Q), such as polydimethylsiloxane (PDMS), acrylic rubber (ACM), ethylene acrylic rubber (AEM), nitrile butadiene rubber (NBR), hydrogenated acrylonitrile butadiene rubber (HNBR), epichlorohydrin rubber (ECO); or (ii) the group of thermoplastics comprising polyacrylates, such as polymethyl methacrylate (PMMA), polystyrene (PS), polybutadiene (PB), polypropylene (PP), polyvinyl chloride (PVC), polycarbonate (PC), polybutylene terephthalate (PBT), polyethylene terephthalate (PET), cyclo olefin polymers (COP), cyclo olefin copolymers (COC), acrylonitrile butadiene styrene (ABS), polyimide (PI), polyetherimide (PEI), polysulfone (PSU); or mixtures thereof.

Polymers which comprise -CH₂-OH, -CH₂-NH₂ or -CH₂-SH functional groups in one or more repeating units are likely to interact and react with the functional groups of the polymeric surface ligand. However, when carefully selecting the processing parameters, particularly the curing parameters (such as curing temperature, curing time and pressure during cure), and when tailoring the used curing system to ensure a homogeneous particle distribution, polymers comprising -CH₂-OH, -CH₂-NH₂ or -CH₂-SH functional groups, such as acrylic resins, epoxy resins (EP), phenolic resins (PF) or epoxy phenol novolacs (EPN), may also be employed as polymer matrix, or the polymer matrix and the polymeric surface ligand may have essentially the same chemical structure.

Preferably, the polymer employed as matrix material in the LC composites according to the present invention is transparent. This signifies that the polymer allows light to pass through the material without significant scattering even at a thickness of the polymer of at least 1 mm, so that at least 80% of the light emitted by the luminescent crystals and a possible light of a light source used for exciting the luminescent crystals are transmitted. Particularly preferably, the polymer is polydimethylsiloxane (PDMS), as this polymer is transparent, highly flexible and stretchable, high-temperature resistant, does not react with the functional groups of the polymeric surface ligand and allows for convenient processing and cure. Thus, embedding of the inventive perovskite luminescent crystal-ligand complex in an in situ crosslinked PDMS allows for an excellent particle distribution and an easy production of thin films.

In a preferred embodiment, the particles are present in the solid polymer in a concentration of 0.0001 wt.-% to 90 wt.-%, preferably 0.1 wt.-% to 50 wt.-%, more preferably 1 wt.-% to 50 wt.-%, even more preferably 1 wt.-% to 10 wt.-%, as within this range, a particularly high photoluminescence quantum yield (PLQY) is obtained whilst a good processability and a good dispersion are ensured.

The particle distribution in the polymer matrix can be controlled for example by visually analyzing the surface or cross-section of the LC composites by means of microscopical imaging, such as light microscopy, transmission electron microscopy (TEM), X-ray diffraction imaging or atomic force microscopy (AFM), or by mechanically analyzing the LC composites by means of hardness measurements or tensile testing, to ensure homogeneity on micro- and macromolecular scale over the entire LC composite.

When using the inventive LC composites at elevated application temperature, care has to be taken to select a polymer as matrix material which has a long-term temperature stability high enough to avoid thermal degradation. For example, the temperature of LEDs can raise to over 100 °C. For high-temperature applications, the polymer therefore needs to have a long-term temperature stability of at least 120 °C, more preferably at least 150 °C, even more preferably at least 180 °C, to avoid thermal aging and degradation during usage. This signifies that amorphous thermoplastics and crosslinked polymers, i.e. elastomers and thermosets, need to have a glass temperature above the application temperature, and semi-crystalline thermoplastics need to have a glass temperature or melting temperature above the application temperature. In any case, it has to be avoided to use a polymer with a transition region, either from the energy-elastic to the entropy-elastic state or from the entropy-elastic to the molten state (of the crystalline phase), being located within the application temperature range of the LC composites, so that homogeneous physical properties over the entire application temperature range are ensured. The thermal and/or thermo-mechanical properties of the polymer or the LC composites can for example be assessed by means of dynamic scanning calorimetry (DSC), thermal gravimetric analysis (TGA) and/or dynamic mechanical analysis (DMA).

In a preferred embodiment, the polymeric surface ligand is a polysiloxane bearing (a) at least one amine group, preferably 2 to 5 amine groups, in the side chains of each of the polymer chains which are bound to the surface of the perovskite luminescent crystals, or (b) having a content of amine groups ranging from 0.5% to 25%; with the amine groups preferably being primary amine groups, and with the molecular weight of the polysiloxane preferably being in the range of 3,000 g/mol to 20,000 g/mol. The polysiloxane may additionally comprise amine groups at one or both end(s) of the polymer backbone chain. It was surprisingly found that by using a polysiloxane with the above-defined molecular weight and the number of amine groups in the above-defined range, the formed perovskite luminescent crystal-ligand complex exhibits an excellent stability and shows a high PLQY of 90% to 95%.

The excellent stability of the inventive perovskite luminescent crystal-ligand complexes with different compositions and thus different emission spectra allows their embedding in the same polymer matrix. Ion-exchange is avoided, thus the distinct emission spectra of perovskite luminescent crystals with different compositions are preserved. The manufacture of separate layers for the generation of different colors is consequently not required, which brings significant benefits in terms of reduced complexity and production costs.

The invention further relates to a method of generating a perovskite luminescent crystal composition comprising providing perovskite luminescent crystals and providing a polymeric surface ligand having a molecular weight of at least 700 g/mol, preferably at least 2,000 g/mol, particularly preferably at least 3,000 g/mol, wherein the polymeric surface ligand is a polymer, namely a polysiloxane, comprising a backbone and side chains, wherein at least one side chains comprises at least one functional group selected from amines, carboxylates, phosphates, thiols or combinations thereof, particularly preferably primary amines, and mixing said perovskite luminescent crystals with the polymeric surface ligand or crystallizing the perovskite luminescence crystals in the presence of the polymeric surface ligand, thereby forming a perovskite luminescent crystal-surface ligand complex.

In a preferred embodiment, the method comprises the generation of the perovskite luminescent crystals in the presence of the surface ligand, wherein the perovskite luminescent crystals are selected from compounds with the formula AₐM_{b}X_{c},
wherein
A represents one or more monovalent cations selected from Cs⁺, Rb⁺, K⁺, Na⁺, Li⁺, ammonium, methylammonium, formamidinium, strontium, guanidinium, imidazolium, pyridinium, pyrrolidinium, protonated thiourea, or a mixture thereof;
M represents one or more metals selected from the group comprising Pb²⁺, Ge²⁺, Sb²⁺, Te²⁺, Sn²⁺, Bi³⁺, Mn²⁺, Cu²⁺, and any rare earth ions, preferably Ce²⁺, Tb²⁺, Eu²⁺, Sm²⁺, Yb²⁺, Dy²⁺, Tm²⁺; and Ag⁺ or Au⁺ or a mixture thereof;
X represents one or more anions selected from the group comprising F⁻, Cl⁻, Br⁻, I⁻, cyanide, thiocyanate, or a mixture thereof;
a is an integer from 1 to 4;
b is an integer of 1 or 2;
c is an integer from 3 to 9;
preferably of formula AMX₃, formula A₄MX₆ or mixtures thereof.

Preferably, the crystallizing of the perovskite luminescent crystals occurs in the presence of the polymeric surface ligand in presence of a polar solvent with a molecular dipole moment of at least 2 Debye, and in the presence of a less polar solvent with a molecular dipole moment of less than 2 Debye. The polar and organic solvent are preferably liquid at a temperature ranging from about 20°C to 25 °C to facilitate manufacture. In a preferred embodiment, the polar and organic solvent have a molecular weight below 200 g/mol. Preferably, the solvents have a boiling point below 140°C, particularly preferably below 120 °C.

The polar solvent may be selected from dimethyl sulfoxide (DMSO), dimethyl formamide (DMF), N-methyl formamide (NMF), N-methyl-2-pyrrolidone (NMP), propylene carbonate, or mixtures thereof, preferably DMSO.

The less polar solvent has a lower polarity than the polar solvent. For example, it may be an organic solvent selected from aliphatic hydrocarbons, aromatic hydrocarbons, ethers, in particular glycol-ethers, esters, alcohols, ketones, amines, amides, sulfones, phosphines, alkyl carbonates, or mixtures thereof, which may also be substituted by one or more substituents, for example by halogen (such as fluor), hydroxy, C₁₋₄ alkoxy, such as methoxy or ethoxy, and alkyl, such as methyl, ethyl, isopropyl. In a preferred embodiment, the less polar solvent is oleic acid. The number of carbon atoms in the less polar solvent is preferably less than 30.

To form the perovskite luminescence crystals, the precursors are dissolved in the polar solvent to form a stock solution. The polymeric surface ligand is preferably added to the less polar solvent, such as toluene combined with a surfactant, such as oleic acid. The stock solution is subsequently added to the less polar solvent comprising the polymeric surface ligand at a temperature below 100 °C, preferably at a temperature ranging from 20 °C to 25 °C, followed by agitation for at least 2 min to form the perovskite luminescent crystals. A subsequent synthesis is preferably performed using a solvent-assisted precipitation method in a reaction solvent, for example in a mixture of DMSO and toluene. The synthesized perovskite luminescent crystals bearing a polymeric surface ligand precipitate in the reaction solvent and can for example be separated by centrifugation, which may be followed by washing, for example with methyl acetate, and drying.

The polymeric surface ligand is preferably bound to the perovskite luminescent crystals during the synthesis, preferably by means of a solvent-assisted precipitation method. However, the synthesis of perovskite luminescent crystals bearing a polymeric surface ligand comprising certain functional groups, such as thiol groups, by means of the above-described solvent-assisted precipitation method is not possible because the high binding affinity of certain functional groups to ions of the precursors inhibits the formation of crystals. For example, the high binding affinity of thiol groups to lead prevents the contribution of lead bromide in the particle formation, which causes lead bromide to remain in the solvent in soluble form. However, these functional groups, such as thiol groups, can successfully be introduced by means of a post-synthetic ligand exchange, which consequently enables the introduction of a broader number of functional groups into the polymeric surface ligand.

In another embodiment of the invention, the perovskite luminescent crystals are provided in powder form and added to a solution of the polymeric surface ligand. Preferably, the solvent(s) is/are subsequently removed, and/or a crosslinking reaction is performed to form a polymer, preferably an elastomer, wherein the perovskite luminescent crystals bearing the polymeric surface ligand are embedded.

In a further embodiment of the invention, the polymeric surface ligand comprises ammonium cations ionically bound to anions instead of the described selected functional groups. These anions may be partially or completely replaced. This replacement comprises the steps of contacting the perovskite luminescent crystals with a polymeric surface ligand comprising an ammonium cation, preferably a primary ammonium cation, which is ionically bound to an anion, preferably a different anion than the anion that is to be replaced, in a fluid.

The synthesis of perovskite luminescent crystals bearing a polymeric surface ligand may be followed by a grinding process to reduce the size of larger-sized crystals and/or agglomerates thereof in order to obtain a homogeneous distribution of their size. For example, the average size of crystals and/or agglomerates thereof along their longest dimension may be reduced to below 5 µm. Shearing force is applied, for example in a manual process by means of a mortar. The crystals and/or agglomerates thereof may be ground whilst still being suspended in the reaction solvent, or, when already being in dry state, may be mixed with a polymer, preferably with the polymer that is intended to form the matrix material in an LC composite. This allows to tailor the shearing force so that the crystals and/or agglomerates are broken down whilst avoiding a desorption of the polymeric surface ligand from the surface of the perovskite luminescent crystals. It is noted that the polymeric surface ligand provides the perovskite luminescent crystals with excellent stability and that no significant degradation of properties is observed as a result of the grinding process, which signifies that mainly agglomerates are broken down during the grinding process and that the surface of the perovskite luminescent crystals remains essentially covered with the polymeric surface ligand after the grinding process. Further, the inventive perovskite luminescent crystal composition exhibits a high brightness (PLQY of 90% to 95%) even after the grinding process. Contrary, perovskite luminescent crystals without a polymeric surface ligand show a poor PLQY of only 5%. This clearly shows the high stability and brightness of the inventive perovskite luminescent crystal composition and the retention of these properties also after the grinding process. The excellent brightness of the inventive perovskite luminescent crystal composition is related to the polymer surface ligand, particularly to its functional groups, more particularly to its functional groups in the side chains, according to the present invention.

The method may further comprise (i) the mixing of a polymer, preferably an elastomer, with the perovskite luminescence crystal-surface ligand complex, or (ii) the formation of a polymer, preferably an elastomer, around the perovskite luminescent crystal-surface ligand complex, to embed the perovskite luminescent crystal-surface ligand complex (in the following referred to as "particles") in the polymer, which is referred to as in situ polymerization and/or in situ crosslinking.

A melted or softened thermoplastic polymer, or liquid and/or semi-solid pre-polymers is/are mixed with the particles and with a suitable curing system. This is followed by in situ polymerization and/or in situ crosslinking of the polymer or the pre-polymers by means of a suitable curing system to generate a polymer, preferably a three-dimensionally crosslinked polymer, particularly preferably an elastomer, wherein the particles are embedded. Pre-polymers that can be used in the present invention to form a solid polymer matrix may be selected from the groups of acrylates, carbonates, sulfones, epoxies, urethanes, imides, esters, furans, amines, styrenes, silicones, and mixtures thereof.

For the in situ crosslinking reaction to be performed, a suitable curing system, i.e. suitable crosslinkers, activators and/or initiators need to be present. Energy can be introduced thermally or via radiation, e.g. by radiation with UV light. As perovskites are capable to act as photoinitiator, an additional photoinitiator may be omitted when using radiation with UV light. Preferably, a thermal curing process is applied. The curing temperature and time need to be selected in accordance with the polymer and the curing system. Preferably, the curing temperature ranges from 80 °C to 180 °C, more preferably from 90 °C to 150 °C, even more preferably from 100 °C to 120 °C, and is particularly preferably 110 °C. The curing time depends on the applied curing temperature and is preferably below 20 min, more preferably below 10 min, most preferably between 3 min and 5 min. In general, the curing reaction is carried out at ambient pressure, however, it may be preferred to carry out the curing reaction under vacuum, or at least to degas the mixture in a vacuum chamber prior to the curing reaction in order to avoid the formation of bubbles which are likely to emerge especially when using liquid pre-polymers to generate an in situ crosslinked polymer network.

The perovskite luminescent crystal composition according to the present invention may be used as a color-generating component, preferably in a display, such as an LCD display or an OLED display, or as charged particles absorber material or photon absorber material, preferably to absorb UV and high energy photons such as X-ray and gamma ray photons or charged particles, or as scintillator material.

The perovskite luminescent crystal composition according to the present invention may further be present in a radiation detection device. Such a radiation detection device comprises, apart from the inventive perovskite luminescent crystal composition, an excitation source and a detection system functionally connected to the perovskite luminescent crystals, preferably wherein the excitation source comprises a source that produces charged particles with high energy or high-energy photons, such as X-ray and gamma rays, charged particles, UV light, with a wavelength of less than 600 nm, preferably less than 480 nm, and/or preferably wherein the detection system comprises a digital camera, a photomultiplier tube (PMT) detector, a thin film transistor (TFT), a photodiode sensor, a CCD sensor, a complementary metal oxide semiconductor (CMOS) sensor or an indium gallium zinc oxide (IGZO) TFT sensor, particularly preferably a digital camera.

The perovskite luminescent crystal composition according to the present invention may be used in a light emitting display cell comprising a light source, preferably a blue light emitting light source or an electrically pumped light source, and a polymer film. The polymer film comprises at least two zones, wherein a first zone is transparent to the light of the light source and a second zone comprises the inventive perovskite luminescent crystal composition. Preferably, the polymer film further comprises a third zone comprising the inventive perovskite luminescent crystal composition, with the emission wavelengths of the perovskite luminescent crystal compositions in the second and third zone upon irradiation by the light source being significantly different from each other so that different colors, preferably red and green, are generated.

The perovskite luminescent crystal composition according to the present invention may be coated with one or two barrier layers when used in a radiation detection device or in a light emitting display cell. Preferably, the material of the barrier layer is selected from the group comprising polyvinylidene chlorides, cyclic olefin copolymers, polyethylene, metal oxides, silicon oxide, silicon nitride or a mixture thereof, optionally in the form of organic and/or inorganic multilayers.

The perovskite luminescent crystal composition according to the present invention may be present in a layer that comprises or is coated with light-scattering particles when used in a radiation detection device or in a light emitting display cell. Preferably, these light-scattering particles have a refractive index of at least 2 and/or an average particle size of 100 nm to 1 µm in their largest dimension. Preferably, the concentration of light-scattering particles in the layer ranges from 1 to 40 wt.-%. TiO₂ or ZrO₂ light-scattering particles are particularly preferred.

### Figures

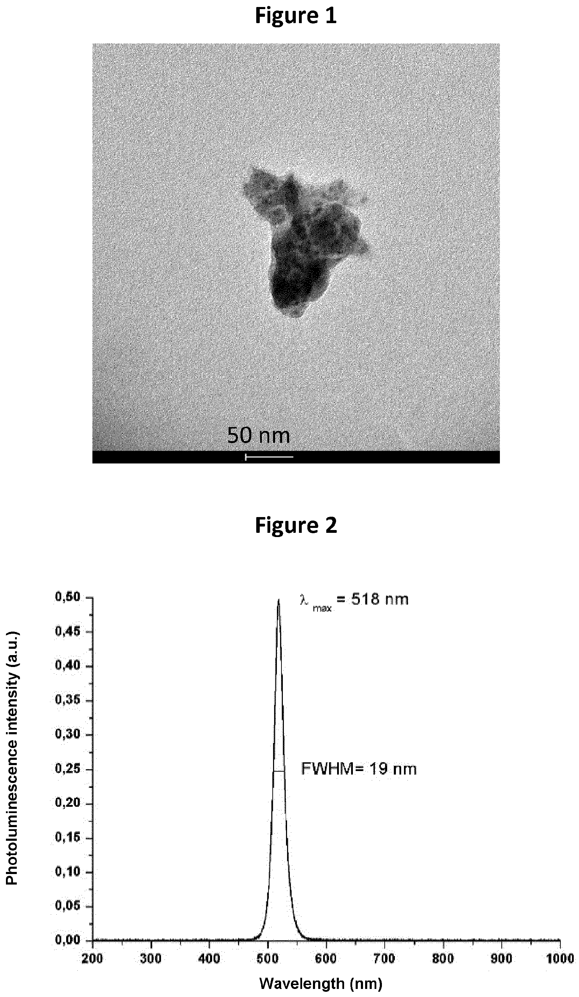

Figure 1: TEM image of ground perovskite luminescent crystals bearing a polysiloxane with amine groups as multidentate polymeric surface ligand, synthesized by means of a solvent-assisted precipitation method
Figure 2: Emission spectrum of green perovskite luminescent crystals in thermally cured PDMS (Sylgard 184). The emission peak is centered at 518 nm and the full width at half maximum (FWHM) is 19 nm.
Figure 3: Emission spectrum of a LC-PDMS composite with perovskite luminescent crystals emitting red and green light, with emission peaks centered at 523 nm and 635 nm, respectively, and with a LED emitting blue light (455 nm) located in the back.
Figure 4: The position of the emission peak of the perovskite LCs in a PDMS film in hardly changed after 3 days under storing at (a) normal condition (25 °C), day light; (b) 85°C, no light; and (c) 35°C, UV light, illustrating its stability.

### Examples

The present invention is further illustrated by the following examples without necessarily being limited to these embodiments of the invention.

### Example 1: Synthesis of perovskite luminescent crystals bearing a polymeric surface ligand using a solvent-assisted precipitation method

In a typical synthesis, PbBr₂ (≥ 98% purity, Sigma Aldrich, 0.4 mmol, 1.46 g) and CsBr (99.9%, Sigma Aldrich, 0.4 mmol, 0.85 g) were dissolved in 100 ml dimethyl sulfoxide (DMSO) to form stock A.

20 ml oleic acid (technical grade with 90% purity, Sigma Aldrich) was mixed with 20 ml (2-3% aminopropylmethylsiloxane)-dimethylsiloxane copolymer (CAS no. 99363-37-8, product code AMS-132, Gelest) for 5 min to form stock B.

Stock A and B were mixed for 5 min to form a metal salt-ligand mixture and swiftly added to 800 ml toluene (99.5% purity for synthesis, Sigma Aldrich) to form a reaction solvent (volume ratio of DMSO to toluene of 1:8). The solution was stirred at 20 °C for 18 h with a rotational speed ranging from 300 rpm to 500 rpm and gradually turned green.

After the synthesis, the formed CsPbBr₃ luminescent crystals precipitated and were separated by centrifugation (4,500 rcf, 30 sec), washed two times with methyl acetate (≥ 99% purity, Sigma Aldrich, 5 ml) and dried under reduced pressure (0.35 mbar) at 20 °C for 18 h to form luminescent crystals (an amount of about 1.21 g to 1.22 g). The synthesized multidentate perovskite luminescent crystals had sizes ranging from 5 nm to 50 µm and an organic content (i.e., content of polymeric surface ligand) of about 5%, as measured by TGA.

### Example 2: Grinding

After the synthesis, the size of the larger-sized perovskite luminescent crystals bearing a polymeric surface ligand according to the present invention was reduced to below 5 µm by applying shearing force and manually mortaring the crystals and/or agglomerates, either whilst still being suspended in the reaction solvent (volume ratio of DMSO to toluene of 1:8), or in the presence of a polymer, preferably the polymer that is intended to form the matrix material of the LC composite.

### Example 3: Polymeric surface ligands

Perovskite luminescent crystals were synthesized using several polymeric surface ligands comprising amine groups, which are listed in Table 1 along with their respective supplier, the amount used in the synthesis, their CAS number and their molecular weight. The PLQY of all obtained crystals ranges from 90% to 95% with an emission peak centered at 518 nm to 520 nm and a FWHM of the emission peak ranging from 18 nm to 20 nm. These properties were measured immediately after washing the crystals with methyl acetate. The use of a multidentate polymeric surface ligand is crucial to protect the perovskite luminescent crystals against degradation. Oleylamine, an unsaturated organic compound comprising only one amine group, fails to provide sufficient stability, as the dried perovskite luminescent crystals bearing oleylamine as surface ligand degraded, turned orange and lost 90% of their PLQY after storage for 2 days at 20 °C under air.

**Table 1: Organic compounds and polymers with amine groups used as surface ligand for the perovskite luminescent crystals according to the present invention**

| **Chemical name** | **Supplier** | **Amount for synthesis (ml)** | **CAS number** | **Molecular weight (g/mol)** |
|---|---|---|---|---|
| Oleylamine¹ | Sigma Aldrich | 1.00 | 112-90-3 | 267.5 |
| Poly(dimethylsiloxane), bis(3-aminopropyl)-terminated | Sigma Aldrich | 3.75 | 106214-84-0 | 2,500 |
| (2-3% Aminopropylmethylsiloxane)-dimethylsiloxane copolymer, AMS-132 | Gelest | 20.00 | 99363-37-8 | 4,500-6,000 |
| (4-5% Aminopropylmethylsiloxane)-dimethylsiloxane copolymer, AMS-152 | Gelest | 10.50 | 99363-37-8 | 7,000-9,000 |
| (6-7% Aminopropylmethylsiloxane)-dimethylsiloxane copolymer, AMS-162 | Gelest | 7.72 | 99363-37-8 | 4,000-5,000 |
| (9-11% Aminopropylmethylsiloxane)-dimethylsiloxane copolymer, AMS-191 | Gelest | 5.00 | 99363-37-8 | 2,000-3,000 |
| (20-25% Aminopropylmethylsiloxane)-dimethylsiloxane copolymer, AMS-1203 | Gelest | 1.10 | 99363-37-8 | 20,000 |
| (0.5-1.5% Aminoethylaminopropyl-methoxysiloxane)-dimethylsiloxane copolymer with branch structure, ATM-1112 | Gelest | 8.50 | 67923-07-3 | 5,000-6,500 |

| | | | | |
|---|---|---|---|---|
| ¹ does not provide sufficient stability | | | | |

Perovskite luminescent crystals formed under similar conditions but in the absence of a polymeric surface ligand showed insufficient stability and immediate degradation, as seen from Table 2. Contrary to the perovskite luminescent crystals bearing a polymeric surface ligand according to the present invention, unprotected perovskite luminescent crystals turned orange immediately after washing with methyl acetate and had only a poor luminescence brightness, as reflected in the low PLQY.

**Table 2: Luminescent characteristics of perovskite luminescent crystals with and without a polymeric surface ligand**

| | **CsBr (mmol)** | **PbBr (mmol)** | **Acid (ml)** | **Polymeric surface ligand** | **DMSO (ml)** | **Toluene (ml)** | **Emission wavelength peak (nm), FWHM, PLQY** |
|---|---|---|---|---|---|---|---|
| Perovskite luminescent crystals bearing a polymeric surface ligand | 4 | 4 | Oleic acid (20 ml) | (2-3% aminopropylmethylsiloxane)-dimethylsiloxane copolymer, 20 ml | 100 | 800 | Emission wavelength |
| | | | | | | | peak = 518 nm; |
| | | | | | | | FWHM = 19 nm; |
| | | | | | | | PLQY = 95% |
| Perovskite luminescent crystals without a polymeric surface ligand | 4 | 4 | 0 | 0 | 100 | 800 | Emission wavelength |
| | | | | | | | peak = 522 nm; |
| | | | | | | | FWHM = 18 nm; |
| | | | | | | | PLQY = 5% |

### Example 4: Manufacture of perovskite luminescent crystals bearing a polymeric surface ligand comprising thiol groups via a post-synthetic ligand exchange

When using a polymeric surface ligand comprising thiol groups in the synthesis, the high binding affinity of thiol groups to lead prevents the contribution of lead bromide in the particle formation, which causes lead bromide to remain in the solvent in soluble form. Thus, the synthesis of perovskite luminescent crystals bearing a polymeric surface ligand comprising thiol groups by means of the above-described solvent-assisted precipitation method is not possible.

However, thiol groups can successfully be introduced by means of a ligand exchange. A multidentate polymeric surface ligand comprising thiol groups was added to a 5 wt.-% particle suspension in the reaction solvent (volume ratio of DMSO to toluene of 1:8). Approximately 2 ml ligand per 1 l reaction solvent were added. The ligand exchange reaction was carried out either after the particle synthesis or during the washing process with 10 ml methyl acetate. The synthesized particles in the reaction solvent or the dried particles in methyl acetate were incubated with the multidentate polymeric surface ligand comprising thiol groups for 2 h at 20 °C under gentle stirring (100 rpm). Following the ligand exchange, the so-formed perovskite luminescent crystal particles bearing a multidentate polymeric surface ligand with thiol groups were separated from the solvent, washed with toluene and dried under reduced pressure (0.35 mbar) at 20 °C.

### Example 5: Preparation of luminescent crystal (LC)-PDMS composites

30 mg of dried perovskite luminescent crystals bearing a multidentate polymeric surface ligand comprising amine groups was mixed with 3 g PDMS (Sylgard 184, Dow Corning Corp.; ratio of base to curing agent of 10:1) and ground for 3 min with a mortar. The mixture was degassed in a vacuum chamber (100 mbar) for 30 min at 20 °C to remove air bubbles. Subsequently, the mixture was cast onto a glass substrate using a film applicator (supplied by TQC Sheen) and cured at 110 °C for 3 min to form a cured LC-PDMS composite film with a thickness of 120 µm and a particle concentration of 1 wt.-%. The PLQY of the obtained particles was 67.8% with an emission peak centered at 519.6 nm and a FWHM of 20.3 nm.

### Example 6: Preparation of luminescent crystal (LC)-PMMA and LC-PS composites

30 mg of dried perovskite luminescent crystals bearing a multidentate polymeric surface ligand comprising amine groups was mixed with 3 g PMMA or PS in toluene (10 wt.-% solution) and ground for 3 min with a mortar. Subsequently, the mixture was cast onto a glass substrate using a film applicator (supplied by TQC Sheen) and the solvent was evaporated slowly under 1 atm at 20 °C to form a cured LC-PMMA or LC-PS composite film with a thickness of 120 µm and a particle concentration of 1 wt.-%. The PLQY of the obtained particles was 65% with an emission peak centered at 518 nm, and the FWHM of the emission was 19 nm.

### Example 7: Preparation of luminescent crystal (LC) composites with a UV curable resin

30 mg of dried perovskite luminescent crystals bearing a multidentate polymeric surface ligand comprising amine groups was mixed with 3 g UV curable resin (CPS 1040 UV-A, Sigma Aldrich) and ground for 3 min with a mortar. The mixture was placed between two pieces of a glass or PET substrate and cured with UV light (365 nm, 2 W) for 30 sec with a distance between sample and light source of about 14 cm to form a cured film with a thickness of 120 µm and a particle concentration of 1 wt.-%. The PLQY of the obtained particles was 64% with an emission peak centered at 521 nm, and the FWHM of the emission was 19 nm.

### Example 8: Influence of aging on the brightness of luminescent crystal (LC)-PDMS composites

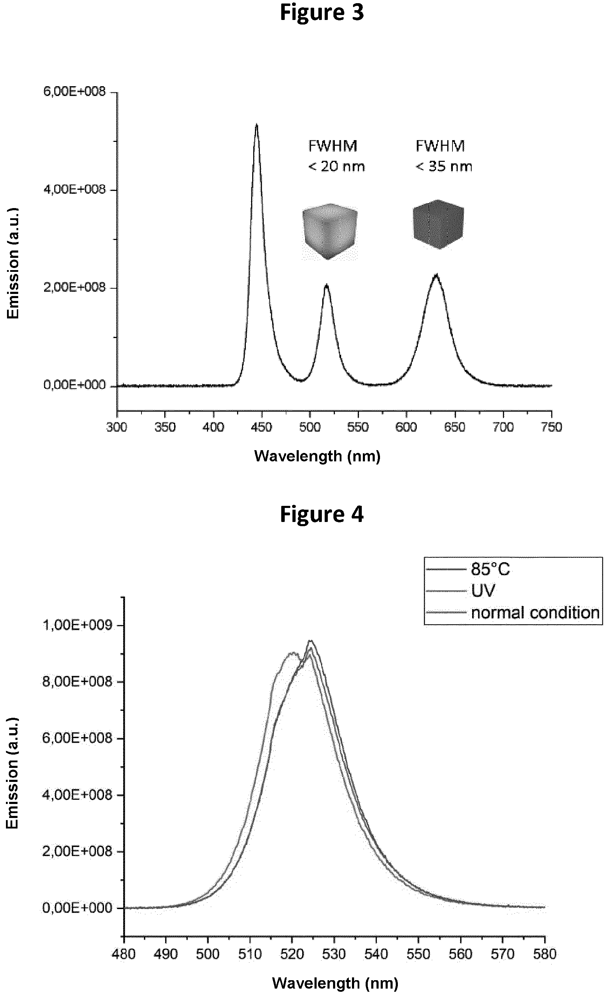

To assess the influence of aging on the brightness, the LC-PDMS composites were sandwiched between PET films with a thickness of 100 µm and stored for 3 days at (a) normal condition (25 °C), day light; (b) 85°C, no light; and (c) 35°C, UV light (Figure 4). The PLQY dropped about 0%, 20% and 40%, respectively, signifying an excellent stability to aging, especially thermal aging. The position of the emission peak of the perovskite luminescent crystals in the LC-PDMS composites remained unchanged after the aging tests.

### Experimental methods:

**Transmission electron microscopy (TEM):** TEM studies were performed with a FEI Tecnai G2 20 transmission electron microscope operating at 160 kV. TEM samples were prepared by dropping a dispersion of 0.1 mg/ml of the inventive perovskite luminescent crystals bearing a polymeric surface ligand in toluene onto a 300-mesh carbon-coated copper grid and subsequently evaporating the solvent in air at approximately 25 °C.

**Measurement of the photoluminescent quantum yield (PLQY):** To assess the emission properties of the inventive perovskite luminescent crystal composition bearing a polymeric surface ligand, a dispersion of 0.1 mg/ml of each inventive composition in toluene was prepared. About 10 µl of each dispersion was dropped onto a PET substrate, followed by sonication for 30 min. A 4-Wavelength High-Power LED Head (LED4D067, Thorlab) with an excitation wavelength of 405 nm (10 mA) equipped with an Advanced 4-Channel LED Driver (DC4100, Thorlab) was used as light source. An integrating sphere (IS200-4, Thorlabs) with a short-pass filter (FES450, Thorlab) was used to measure the amount of emitted light and to obtain reflectance spectra without absorbance. The scattering loss was estimated and the photoluminescence quantum yield (PLQY) was calculated by dividing the number of emitted photons by the number of absorbed photons.

**Thermogravimetric analysis (TGA):** TGA curves were recorded with a Mettler-Toledo TGA/DSC 1 STAR System in the temperature range from 25 °C to 650°C with a heating rate of 10 K/min in synthetic air. For each measurement, 5 mg per inventive perovskite luminescent crystal composition bearing a polymeric surface ligand was used (after drying), and the mass loss at 650 °C was evaluated to assess the organic content (i.e., the content of polymeric surface ligand).

## Claims

1. Perovskite luminescent crystal composition comprising perovskite luminescent crystals bearing a polymeric surface ligand with a molecular weight of at least 700 g/mol, wherein the polymeric surface ligand is a polysiloxane comprising a backbone and side chains, wherein at least one side chain comprises at least one functional group selected from amines, carboxylates, phosphates, thiols or combinations thereof, wherein the binding of the perovskite luminescent crystals to the surface ligand occurs through the surface ligand's functional groups, thereby forming a perovskite luminescent crystal-ligand complex.

2. The perovskite luminescent crystal composition of claim 1, wherein the polymeric surface ligand has a molecular weight in the range of 700 g/mol to 400,000 g/mol, preferably 2,000 g/mol to 20,000 g/mol, particularly preferably 3,000 g/mol to 20,000 g/mol.

3. The perovskite luminescent crystal composition of claim 1 or 2, wherein the perovskite luminescent crystals are selected from compounds with the formula AₐM_{b}X_{c},
wherein
A represents one or more monovalent cations selected from Cs⁺, Rb⁺, K⁺, Na⁺, Li⁺, ammonium, methylammonium, formamidinium, strontium, guanidinium, imidazolium, pyridinium, pyrrolidinium, protonated thiourea, or a mixture thereof;
M represents one or more metals selected from the group comprising Pb²⁺, Ge²⁺, Sb²⁺, Te²⁺, Sn²⁺, Bi³⁺, Mn²⁺, Cu²⁺, and any rare earth ions, preferably Ce²⁺, Tb²⁺, Eu²⁺, Sm²⁺, Yb²⁺, Dy²⁺, Tm²⁺; and Ag⁺ or Au⁺ or a mixture thereof;
X represents one or more anions selected from the group comprising F⁻, Cl⁻, Br⁻, I⁻, cyanide, thiocyanate, or a mixture thereof;
a is an integer from 1 to 4;
b is an integer of 1 or 2;
c is an integer from 3 to 9;
preferably of formula AMX₃, formula A₄MX₆ or mixtures thereof.

4. The perovskite luminescent crystal composition of any one of the preceding claims, wherein the polymeric surface ligand comprises a backbone with backbone atoms selected from C, O, N, Si, S, and wherein (a) at least 0.0025 mol.-% of side chains of the polymeric surface ligand comprise one or more of the functional groups, or (b) the side chains of the polymeric surface ligand comprise at least one of the functional groups for every 800 backbone atoms of the polymeric surface ligand.

5. The perovskite luminescent crystal composition of any one of the preceding claims, wherein the backbone comprises the structure of repeating subunits selected from -Si-O-, -C-O-, -C-C-, -C-C-O-, -Si-C-, -Si-C-O-, -Si-O-C-O-, -C-S-, -C-S-C-, wherein any C and/or Si can be independently substituted, and/or wherein the side chains comprise a functional group-containing structure -Z-L with Z being a group selected from branched, cyclic or linear C₁₋₃₀ alkyl, C₁₋₃₀ alkenyl, C₁₋₃₀ alkynyl, C₁₋₃₀ aryl, C₁₋₃₀ cycloalkyl, wherein 1 or more C may be hetero-substituted by O, N, Si, S or P, and L being selected from the functional groups; preferably wherein at least every 100 repeating subunit comprises one functional group-containing structure.

6. The perovskite luminescent crystal composition of any one of the preceding claims, wherein the polymeric surface ligand has the general formula 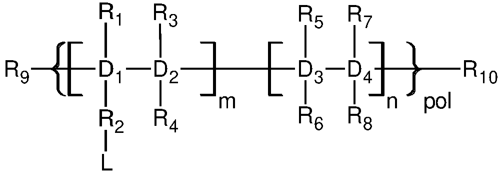 wherein
D₁ is selected from Si, C;
D₂ is absent or selected from Si, C, O, N, S;
D₃ is selected from Si, C, O, S;
D₄ is absent or selected from Si, C, O, N, S;
m is an integer from 0 to 2,000;
n is an integer from 0 to 2,000;
R₁, R₂, R₃, R₄, R₅, R₆, R₇, R₈ are independently selected from being absent, H, branched, cyclic or linear C₁₋₃₀ alkyl, C₁₋₃₀ alkenyl, C₁₋₃₀ alkynyl, being optionally O, S, N or P hetero substituted, preferably selected from methyl, ethyl, propyl, isopropyl, butyl, isobutyl, tert-butyl, vinyl, acryl, methacryl, ethyl aminopropyl, ethyl aminoethyl;
wherein R₃ and R₄ are absent when D₂ is absent, O, N or S;
wherein R₇ and R₈ are absent when D₄ is absent, O, N or S;
L is absent or selected from the group of amines, carboxylates, phosphates, thiols, vinyls, vinyl siloxanes, alkoxysilyls, -Si(CH₃)₃, epoxides, carbinols, acrylates, saturated or unsaturated hydrocarbons, aromatic hydrocarbons, aliphatic hydrocarbons, cyclic or branched hydrocarbons, halogenated or non-halogenated hydrocarbons or a mixture thereof;
R₉ and R₁₀ are absent or independently selected from the group of amines, carboxylates, phosphates, hydroxy groups, thiols or a mixture thereof;
wherein R₉ and R₁₀ are present, R₉ and L are present, R₁₀ and L are present, L is present, or R₉, R₁₀ and
L are present;
pol is the average degree of polymerization, preferably a number of 4 to 5401;
or wherein the polymeric surface ligand is a copolymer with the following subunits: 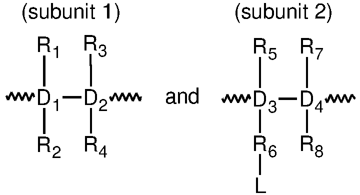
wherein D₁, D₂, D₃, D₄, R₁, R₂, R₃, R₄, R₅, R₆, R₇, R₈, L have the above meaning, the subunits are connected at backbone atoms D1, D2, D3, and D4, and wherein the molecular ratio of subunit 2 to subunit 1 in the copolymer is 0.0025 to 1.

7. The perovskite luminescent crystal composition of any one of the preceding claims, wherein the perovskite luminescent crystal-ligand complex is embedded in a polymer, preferably an elastomer.

8. The perovskite luminescent crystal composition of claim 7, wherein the polymer is devoid of -CH₂-OH, - CH₂-NH₂ or -CH₂-SH functional groups or comprises these functional groups in amounts of less than 1 functional group per 1,000 backbone atoms of the polymeric surface ligand; preferably wherein the polymer has the backbone defined for the surface ligand in claim 5 or 6 but is devoid of L, or preferably wherein the polymer is selected from poly(methyl methacrylate) (PMMA), polydimethylsiloxane (PDMS), polystyrene (PS), polyethylene terephthalate (PET).

9. A method of generating a composition of any one of the preceding claims, comprising providing perovskite luminescent crystals and providing a polymeric surface ligand with a molecular weight of at least 700 g/mol, wherein the polymeric surface ligand is a polysiloxane comprising a backbone and side chains, wherein at least one side chain comprises at least one functional group selected from amines, carboxylates, phosphates, thiols or combinations thereof, and mixing said perovskite luminescent crystals with the polymeric surface ligand and/or crystallizing the perovskite luminescent crystals in the presence of the polymeric surface ligand, thereby forming a perovskite luminescent crystal-surface ligand complex.

10. The method of claim 9, comprising generating the perovskite luminescent crystals in the presence of the polymeric surface ligand, wherein the perovskite luminescent crystals are selected from compounds with the formula AₐM_{b}X_{c},
wherein
A represents one or more monovalent cations selected from Cs⁺, Rb⁺, K⁺, Na⁺, Li⁺, ammonium, methylammonium, formamidinium, strontium, guanidinium, imidazolium, pyridinium, pyrrolidinium, protonated thiourea, or a mixture thereof;
M represents one or more metals selected from the group comprising Pb²⁺, Ge²⁺, Sb²⁺, Te²⁺, Sn²⁺, Bi³⁺, Mn²⁺, Cu²⁺, and any rare earth ions, preferably Ce²⁺, Tb²⁺, Eu²⁺, Sm²⁺, Yb²⁺, Dy²⁺, Tm²⁺; and Ag⁺ or Au⁺ or a mixture thereof;
X represents one or more anions selected from the group comprising F⁻, Cl⁻, Br⁻, I⁻, cyanide, thiocyanate, or a mixture thereof;
a is an integer from 1 to 4;
b is an integer of 1 or 2;
c is an integer from 3 to 9;
preferably of formula AMX₃, formula A₄MX₆ or mixtures thereof.

11. The method of claim 9 or 10, further comprising mixing of a polymer, preferably an elastomer, with the perovskite luminescent crystal-surface ligand complex, or forming a polymer around the perovskite luminescent crystal-surface ligand complex to embed the perovskite luminescent crystal-surface ligand complex in the polymer.

12. A method of partially replacing the anions in a perovskite luminescent crystal composition of claim 3, comprising the step of contacting the perovskite luminescent crystals with a polymeric surface ligand comprising an ammonium cation, preferably a primary ammonium cation, ionically bound to an anion, preferably a different anion than the anion to be replaced, in a fluid, wherein the polymeric surface ligand is the polymeric surface ligand of any one of claims 1 to 7 with the exception that it comprises the ammonium cation ionically bound to an anion instead of the selected functional groups.

13. Use of the perovskite luminescent crystal composition of any one of claims 1 to 8 as color generating component, preferably in a display or as charged particles absorber material or photon absorber material, preferably to absorb UV and high energy photons such as X-ray and gamma ray photons or charged particles, or as scintillator material.

14. A radiation detection device comprising a perovskite luminescent crystal composition of any one of claims 1 to 8, an excitation source and a detection system functionally connected to the perovskite luminescent crystal composition, preferably wherein the excitation source comprises a source that produces charged particles with high energy or high-energy photons with a wavelength of less than 600 nm, preferably less than 480 nm, and/or preferably wherein the detection system comprises a digital camera, a photomultiplier tube (PMT) detector, a thin film transistor (TFT), a photodiode sensor, a CCD sensor, a complementary metal oxide semiconductor (CMOS) sensor or an indium gallium zinc oxide (IGZO) TFT sensor, particularly preferably a digital camera.

15. A light emitting display cell comprising a light source, preferably a blue light emitting source or an electrically pumped light source, and a polymer film, wherein the polymer film comprises at least two zones, wherein a first zone is transparent to the light of the light source and a second zone comprises a perovskite luminescent crystal composition of any one of claims 1 to 8 in the polymer film, preferably further comprising a third zone comprising a perovskite luminescent crystal composition of any one of claims 1 to 8 in the polymer film, wherein preferably the perovskite luminescent crystals of the second and third zone emit light at different wavelengths upon irradiation by the light source, preferably red and green light.

## Patentansprüche

1. Lumineszierende Perowskit-Kristallzusammensetzung, umfassend lumineszierende Perowskit-Kristalle mit einem polymeren Oberflächenliganden mit einem Molekulargewicht von mindestens 700 g/Mol, wobei der polymere Oberflächenligand ein Polysiloxan ist, das ein Rückgrat und Seitenketten umfasst, wobei mindestens eine Seitenkette mindestens eine funktionelle Gruppe umfasst, die aus Aminen, Carboxylaten, Phosphaten, Thiolen oder Kombinationen davon ausgewählt ist, wobei die Bindung der lumineszierenden Perowskit-Kristalle an den Oberflächenliganden durch die funktionellen Gruppen des Oberflächenliganden erfolgt, wodurch ein lumineszierender Perowskit-Kristall-Ligand-Komplex gebildet wird.

2. Lumineszierende Perowskit-Kristallzusammensetzung nach Anspruch 1, wobei der polymere Oberflächenligand ein Molekulargewicht im Bereich von 700 g/Mol bis 400.000 g/Mol, bevorzugt 2.000 g/Mol bis 20.000 g/Mol, besonders bevorzugt 3.000 g/Mol bis 20.000 g/Mol aufweist.

3. Die lumineszierende Perowskit-Kristallzusammensetzung nach Anspruch 1 oder 2, wobei die lumineszierenden Perowskit-Kristalle aus Verbindungen mit der Formel AₐM_{b}X_{c} ausgewählt sind,
wobei
A ein oder mehrere einwertige Kationen, ausgewählt aus Cs⁺, Rb⁺, K⁺, Na⁺, Li⁺, Ammonium, Methylammonium, Formamidinium, Strontium, Guanidinium, Imidazolium, Pyridinium, Pyrrolidinium, protoniertem Thioharnstoff oder einer Mischung davon repräsentiert;
M ein oder mehrere Metalle, ausgewählt aus der Gruppe umfassend Pb²⁺, Ge²⁺, Sb²⁺, Te²⁺, Sn²⁺, Bi³⁺, Mn²⁺, Cu²⁺, und beliebige Seltenerdionen, bevorzugt Ce²⁺, Tb²⁺, Eu²⁺, Sm²⁺, Yb²⁺, Dy²⁺, Tm²⁺; und Ag⁺ oder Au⁺ oder eine Mischung davon repräsentiert;
X ein oder mehrere Anionen, ausgewählt aus der Gruppe, die F, Cl⁻, Br, I⁻, Cyanid, Thiocyanat oder eine Mischung davon umfasst, repräsentiert;
a eine ganze Zahl von 1 bis 4 ist;
b eine ganze Zahl von 1 oder 2 ist;
c eine ganze Zahl von 3 bis 9 ist;
bevorzugt der Formel AMX₃, der Formel A₄MX₆ oder Mischungen davon.

4. Lumineszierende Perowskit-Kristallzusammensetzung nach einem der vorhergehenden Ansprüche, wobei der polymere Oberflächenligand ein Rückgrat mit Rückgratatomen, ausgewählt aus C, O, N, Si, S, umfasst, und wobei (a) mindestens 0,0025 Mol-% der Seitenketten des polymeren Oberflächenliganden eine oder mehrere der funktionellen Gruppen umfassen, oder (b) die Seitenketten des polymeren Oberflächenliganden mindestens eine der funktionellen Gruppen für alle 800 Rückgratatome des polymeren Oberflächenliganden umfassen.

5. Lumineszierende Perowskit-Kristallzusammensetzung nach einem der vorhergehenden Ansprüche, wobei das Rückgrat die Struktur von sich wiederholenden Untereinheiten umfasst, die aus -Si-O-, -C-O-, -C-C-, -C-C-O-, -Si-C-, -Si-C-O-, -Si-O-C-O-, -C-S-, -C-S-C-ausgewählt sind, wobei jedes C und/oder Si unabhängig voneinander substituiert sein kann, und/oder wobei die Seitenketten eine eine funktionelle Gruppe enthaltende Struktur -Z-L umfassen, wobei Z eine Gruppe ist, die aus verzweigtem, zyklischem oder linearem C₁₋₃₀-Alkyl, C₁₋₃₀-Alkenyl, C₁₋₃₀-Alkinyl, C₁₋₃₀-Aryl, C₁₋₃₀-Cycloalkyl ausgewählt ist, wobei 1 oder mehrere C durch O, N, Si, S oder P heterosubstituiert sein können, und L aus den funktionellen Gruppen ausgewählt ist; bevorzugt wobei mindestens alle 100 sich wiederholenden Untereinheiten eine eine funktionelle Gruppe enthaltende Struktur umfassen.

6. Lumineszierende Perowskit-Kristallzusammensetzung nach einem der vorhergehenden Ansprüche, wobei der polymere Oberflächenligand die allgemeine Formel hat: 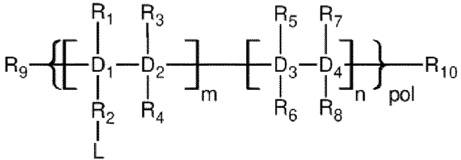 wobei
D₁ aus Si, C ausgewählt ist;
D₂ fehlend oder aus Si, C, O, N, S ausgewählt ist;
D₃ aus Si, C, O, S ausgewählt ist;
D₄ fehlend oder aus Si, C, O, N, S ausgewählt ist;
m eine ganze Zahl von 0 bis 2.000 ist;
n eine ganze Zahl von 0 bis 2.000 ist;
R₁, R₂, R₃, R₄, R₅, R₆, R₇, R₈ unabhängig voneinander aus fehlend, H, verzweigtem, zyklischem oder linearem C₁₋₃₀-Alkyl, C₁₋₃₀-Alkenyl, C₁₋₃₀-Alkinyl, gegebenenfalls O-, S-, N- oder P-heterosubstituiert, bevorzugt ausgewählt aus Methyl, Ethyl, Propyl, Isopropyl, Butyl, Isobutyl, tert.-Butyl, Vinyl, Acryl, Methacryl, Ethylaminopropyl, Ethylaminoethyl ausgewählt sind;
wobei R₃und R₄ fehlend sind, wenn D₂ fehlend, O, N oder S ist;
wobei R₇ und R₈ fehlend sind, wenn D₄ fehlend, O, N oder S ist;
L fehlend oder aus der Gruppe der Amine, Carboxylate, Phosphate, Thiole, Vinyle, Vinylsiloxane, Alkoxysilyle, -Si(CH₃)₃, Epoxide, Carbinole, Acrylate, gesättigte oder ungesättigte Kohlenwasserstoffe, aromatische Kohlenwasserstoffe, aliphatische Kohlenwasserstoffe, zyklische oder verzweigte Kohlenwasserstoffe, halogenierte oder nichthalogenierte Kohlenwasserstoffe oder einer Mischung davon ausgewählt ist;
R₉ und R₁₀ fehlend oder unabhängig voneinander aus der Gruppe der Amine, Carboxylate, Phosphate, Hydroxygruppen, Thiole oder einer Mischung davon ausgewählt sind;
wobei R₉ und R₁₀ vorhanden sind, R₉ und L vorhanden sind, R₁₀ und L vorhanden sind, L vorhanden ist, oder R₉, R₁₀ und L vorhanden sind;
pol der durchschnittliche Polymerisationsgrad, bevorzugt eine Zahl von 4 bis 5401, ist;
oder wobei der polymere Oberflächenligand ein Copolymer mit den folgenden Untereinheiten ist: 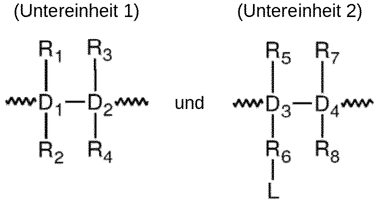
wobei D₁, D₂, D₃, D₄, R₁, R₂, R₃, R₄, R₅, R₆, R₇, R₈, L die obige Bedeutung haben, die Untereinheiten an den Rückgratatomen D1, D2, D3 und D4 verbunden sind und wobei das molekulare Verhältnis der Untereinheit 2 zur Untereinheit 1 im Copolymer 0,0025 zu 1 beträgt.

7. Lumineszierende Perowskit-Kristallzusammensetzung nach einem der vorhergehenden Ansprüche, wobei der lumineszierende Perowskit-Kristall-Ligand-Komplex in ein Polymer, bevorzugt ein Elastomer, eingebettet ist.

8. Lumineszierende Perowskit-Kristallzusammensetzung nach Anspruch 7, wobei das Polymer keine funktionellen Gruppen -CH₂-OH, -CH₂-NH₂oder -CH₂-SH enthält oder diese funktionellen Gruppen in Mengen von weniger als 1 funktionellen Gruppe pro 1000 Rückgratatome des polymeren Oberflächenliganden umfasst; bevorzugt, wobei das Polymer das für den Oberflächenliganden in Anspruch 5 oder 6 definierte Rückgrat aufweist, aber kein L enthält, oder bevorzugt wobei das Polymer ausgewählt ist aus Poly(methylmethacrylat) (PMMA), Polydimethylsiloxan (PDMS), Polystyrol (PS), Polyethylenterephthalat (PET).

9. Verfahren zum Herstellen einer Zusammensetzung nach einem der vorhergehenden Ansprüche, umfassend das Bereitstellen von lumineszierenden Perowskit-Kristallen und das Bereitstellen eines polymeren Oberflächenliganden mit einem Molekulargewicht von mindestens 700 g/mol, wobei der polymere Oberflächenligand ein Polysiloxan ist, das ein Rückgrat und Seitenketten umfasst, wobei mindestens eine Seitenkette mindestens eine funktionelle Gruppe umfasst, die aus Aminen, Carboxylaten, Phosphaten, Thiolen oder Kombinationen davon ausgewählt ist, und Mischen der lumineszierenden Perowskit-Kristalle mit dem polymeren Oberflächenliganden und/oder Kristallisieren der lumineszierenden Perowskit-Kristalle in Gegenwart des polymeren Oberflächenliganden, wodurch ein lumineszierender Perowskit-Kristall-Oberflächenligand-Komplex gebildet wird.

10. Verfahren nach Anspruch 9, umfassend das Herstellen der lumineszierenden Perowskit-Kristalle in Gegenwart des polymeren Oberflächenliganden, wobei die lumineszierenden Perowskit-Kristalle aus Verbindungen mit der Formel AₐM_{b}X_{c} ausgewählt sind,
wobei
A ein oder mehrere einwertige Kationen, ausgewählt aus Cs⁺, Rb⁺, K⁺, Na⁺, Li⁺, Ammonium, Methylammonium, Formamidinium, Strontium, Guanidinium, Imidazolium, Pyridinium, Pyrrolidinium, protoniertem Thioharnstoff oder einer Mischung davon repräsentiert;
M ein oder mehrere Metalle, die aus der Gruppe ausgewählt sind, die Pb²⁺, Ge²⁺, Sb²⁺, Te²⁺, Sn²⁺, Bi³⁺, Mn²⁺, Cu²⁺ und beliebige Seltenerdionen, bevorzugt Ce²⁺, Tb²⁺, Eu²⁺, Sm²⁺, Yb²⁺, Dy²⁺, Tm²⁺; und Ag⁺ oder Au⁺ oder eine Mischung davon enthält, repräsentiert;
X ein oder mehrere Anionen, ausgewählt aus der Gruppe, die F⁻, Cl⁻, Br⁻, I⁻, Cyanid, Thiocyanat oder eine Mischung davon umfasst, repräsentiert;
a eine ganze Zahl von 1 bis 4 ist;
b eine ganze Zahl von 1 oder 2 ist;
c eine ganze Zahl von 3 bis 9 ist;
bevorzugt der Formel AMX₃, der Formel A₄MX₆ oder Mischungen davon.

11. Verfahren nach Anspruch 9 oder 10, ferner umfassend das Mischen eines Polymers, bevorzugt eines Elastomers, mit dem lumineszierenden Perowskit-Kristall-Oberflächenliganden-Komplex oder das Bilden eines Polymers um den lumineszierenden Perowskit-Kristall-Oberflächenliganden-Komplex, um den lumineszierenden Perowskit-Kristall-Oberflächenliganden-Komplex in das Polymer einzubetten.

12. Verfahren zum teilweisen Ersetzen der Anionen in einer lumineszierenden Perowskit-Kristallzusammensetzung nach Anspruch 3, umfassend den Schritt des Inkontaktbringens der lumineszierenden Perowskit-Kristalle mit einem polymeren Oberflächenliganden, umfassend ein Ammoniumkation, bevorzugt ein primäres Ammoniumkation, das ionisch an ein Anion gebunden ist, bevorzugt ein anderes Anion als das zu ersetzende Anion, in einer Flüssigkeit, wobei der polymere Oberflächenligand der polymere Oberflächenligand nach einem der Ansprüche 1 bis 7 ist, mit der Ausnahme, dass er das Ammoniumkation umfasst, das anstelle der ausgewählten funktionellen Gruppen ionisch an ein Anion gebunden ist.

13. Verwendung der lumineszierenden Perowskit-Kristallzusammensetzung nach einem der Ansprüche 1 bis 8 als farbgebende Komponente, vorzugsweise in einer Anzeige oder als Absorbermaterial für geladene Teilchen oder Photonen, bevorzugt zur Absorption von UV- und Hochenergiephotonen wie Röntgen- und Gammastrahlenphotonen oder geladenen Teilchen, oder als Szintillatormaterial.

14. Strahlungsdetektionsvorrichtung, umfassend eine lumineszierende Perowskit-Kristallzusammensetzung nach einem der Ansprüche 1 bis 8, eine Anregungsquelle und ein Detektionssystem, das funktionell mit der lumineszierenden Perowskit-Kristallzusammensetzung verbunden ist, wobei die Anregungsquelle eine Quelle umfasst, die geladene Teilchen mit hoher Energie oder hochenergetische Photonen mit einer Wellenlänge von weniger als 600 nm erzeugt, bevorzugt weniger als 480 nm, und/oder bevorzugt umfasst das Detektionssystem eine Digitalkamera, einen Photomultiplier Tube (PMT)-Detektor, einen Dünnfilmtransistor (TFT), einen Photodioden-Sensor, einen CCD-Sensor, einen komplementären Metalloxid-Halbleiter (CMOS)-Sensor oder einen Indium-Gallium-Zinkoxid (IGZO)-TFT-Sensor, besonders bevorzugt eine Digitalkamera.

15. Lichtemittierende Anzeigezelle, umfassend eine Lichtquelle, vorzugsweise eine blaues Licht emittierende Quelle oder eine elektrisch gepumpte Lichtquelle, und einen Polymerfilm, wobei der Polymerfilm mindestens zwei Zonen umfasst, wobei eine erste Zone für das Licht der Lichtquelle transparent ist und eine zweite Zone eine lumineszierende Perowskit-Kristallzusammensetzung nach einem der Ansprüche 1 bis 8 im Polymerfilm umfasst, bevorzugt ferner umfassend eine dritte Zone, die eine lumineszierende Perowskit-Kristallzusammensetzung nach einem der Ansprüche 1 bis 8 im Polymerfilm umfasst, wobei bevorzugt die lumineszierenden Perowskit-Kristalle der zweiten und dritten Zone bei Bestrahlung durch die Lichtquelle Licht mit unterschiedlichen Wellenlängen, bevorzugt rotes und grünes Licht, emittieren.

## Revendications

1. Composition de cristaux luminescents de pérovskite comprenant des cristaux luminescents de pérovskite portant un ligand de surface polymère avec un poids moléculaire d'au moins 700 g/mol, dans laquelle le ligand de surface polymère est un polysiloxane comprenant une chaîne principale et des chaînes latérales, dans laquelle au moins une chaîne latérale comprend au moins un groupe fonctionnel sélectionné parmi les amines, les carboxylates, les phosphates, les thiols ou leurs combinaisons, dans laquelle la liaison des cristaux luminescents de pérovskite au ligand de surface se produit par l'intermédiaire des groupes fonctionnels du ligand de surface, formant ainsi un complexe cristal luminescent de pérovskite-ligand.

2. Composition de cristaux luminescents de pérovskite selon la revendication 1, dans laquelle le ligand de surface polymère a un poids moléculaire dans la plage de 700 g/mol à 400 000 g/mol, de préférence de 2 000 g/mol à 20 000 g/mol, particulièrement de préférence de 3 000 g/mol à 20 000 g/mol.

3. La composition de cristaux luminescents de pérovskite selon la revendication 1 ou 2, dans laquelle les cristaux luminescents de pérovskite sont sélectionnés parmi les composés de formule AₐM_{b}X_{c},
dans laquelle
A représente un ou plusieurs cations monovalents sélectionnés parmi Cs⁺, Rb⁺, K⁺, Na⁺, Li⁺, ammonium, méthylammonium, formamidinium, strontium, guanidinium, imidazolium, pyridinium, pyrrolidinium, thiourée protonée, ou un mélange de ceux-ci ;
M représente un ou plusieurs métaux sélectionnés dans le groupe comprenant Pb²⁺, Ge²⁺, Sb²⁺, Te²⁺, Sn²⁺, Bi³⁺, Mn²⁺, Cu²⁺, et tous les ions de terres rares, de préférence Ce²⁺, Tb²⁺, Eu²⁺, Sm²⁺, Yb²⁺, Dy²⁺, Tm²⁺ ; et Ag⁺ ou Au⁺ ou un mélange de ceux-ci ;
X représente un ou plusieurs anions sélectionnés dans le groupe comprenant F⁻, Cl⁻, Br⁻, I⁻, cyanure, thiocyanate, ou un mélange de ceux-ci ;
a est un entier de 1 à 4 ;
b est un entier de 1 ou 2 ;
c est un entier de 3 à 9 ;
de préférence de formule AMX₃, formule A₄MX₆ ou des mélanges de celles-ci.

4. La composition de cristaux luminescents de pérovskite selon l'une des revendications précédentes, dans laquelle le ligand de surface polymère comprend une chaîne principale avec des atomes de chaîne principale sélectionnés parmi C, O, N, Si, S, et dans laquelle (a) au moins 0,0025 % mol. des chaînes latérales du ligand de surface polymère comprennent un ou plusieurs des groupes fonctionnels, ou (b) les chaînes latérales du ligand de surface polymère comprennent au moins un des groupes fonctionnels pour chaque 800 atomes de chaîne principale du ligand de surface polymère.

5. La composition de cristaux luminescents de pérovskite selon l'une des revendications précédentes, dans laquelle la chaîne principale comprend la structure de sous-unités répétitives sélectionnées parmi -Si-O-, -C-O-, -C-C-, -C-C-O-, -Si-C-, -Si-C-O-, -Si-O-C-O-, -C-S-, -C-S-C-, dans laquelle tout C et/ou Si peut être indépendamment substitué, et/ou dans laquelle les chaînes latérales comprennent une structure contenant un groupe fonctionnel -Z-L avec Z étant un groupe sélectionné parmi les groupes alkyle C₁₋₃₀, alcényle C₁₋₃₀, alcynyle C₁₋₃₀, aryle C₁₋₃₀, cycloalkyle C₁₋₃₀ ramifiés, cycliques ou linéaires, dans lesquels 1 ou plusieurs C peuvent être hétéro-substitués par O, N, Si, S ou P, et L étant sélectionné parmi les groupes fonctionnels ; de préférence dans laquelle au moins chaque 100 sous-unités répétitives comprend une structure contenant un groupe fonctionnel.

6. La composition de cristaux luminescents de pérovskite selon l'une des revendications précédentes, dans laquelle le ligand de surface polymère a la formule générale : 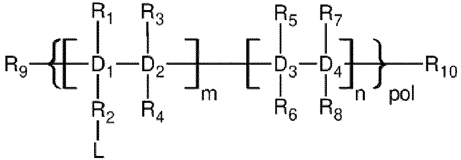 dans laquelle
D₁ est sélectionné parmi Si, C ;
D₂ est absent ou sélectionné parmi Si, C, O, N, S ;
D₃ est sélectionné parmi Si, C, O, S ;
D₄ est absent ou sélectionné parmi Si, C, O, N, S ;
m est un entier de 0 à 2 000 ;
n est un entier de 0 à 2 000 ;
R₁, R₂, R₃, R₄, R₅, R₆, R₇, R₈ sont indépendamment sélectionnés parmi étant absent, H, alkyle C₁₋₃₀, alcényle C₁₋₃₀, alcynyle C₁₋₃₀ ramifié, cyclique ou linéaire, étant optionnellement hétéro-substitués par O, S, N ou P, de préférence sélectionnés parmi méthyle, éthyle, propyle, isopropyle, butyle, isobutyle, tert-butyle, vinyle, acryle, méthacryle, éthyle aminopropyle, éthyle aminoéthyle ;
dans laquelle R₃ et R₄ sont absents lorsque D₂ est absent, O, N ou S ;
dans laquelle R₇ et R₈ sont absents lorsque D₄ est absent, O, N ou S ;
L est absent ou sélectionné dans le groupe des amines, carboxylates, phosphates, thiols, vinyles, vinyle siloxanes, alkoxysilyles, -Si(CH₃)₃, époxydes, carbinols, acrylates, hydrocarbures saturés ou insaturés, hydrocarbures aromatiques, hydrocarbures aliphatiques, hydrocarbures cycliques ou ramifiés, hydrocarbures halogénés ou non halogénés ou un mélange de ceux-ci ;
R₉ et R₁₀ sont absents ou indépendamment sélectionnés dans le groupe des amines, carboxylates, phosphates, groupes hydroxy, thiols ou un mélange de ceux-ci ;
dans laquelle R₉ et R₁₀ sont présents, R₉ et L sont présents, R₁₀ et L sont présents, L est présent, ou R₉, R₁₀ et L sont présents ;
pol est le degré moyen de polymérisation, de préférence un nombre de 4 à 5401 ;
ou dans laquelle le ligand de surface polymère est un copolymère avec les sous-unités suivantes : 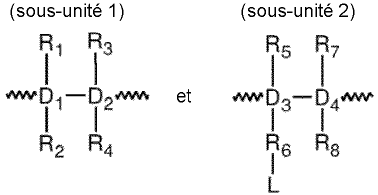
dans laquelle D₁, D₂, D₃, D₄, R₁, R₂, R₃, R₄, R₅, R₆, R₇, R₈, L ont la signification ci-dessus, les sous-unités sont connectées aux atomes de chaîne principale D₁, D₂, D₃ et D₄, et dans laquelle le rapport moléculaire de la sous-unité 2 à la sous-unité 1 dans le copolymère est de 0,0025 à 1.

7. La composition de cristaux luminescents de pérovskite selon l'une des revendications précédentes, dans laquelle le complexe cristal luminescent de pérovskite-ligand est incorporé dans un polymère, de préférence un élastomère.

8. La composition de cristaux luminescents de pérovskite selon la revendication 7, dans laquelle le polymère est dépourvu de groupes fonctionnels -CH₂-OH, -CH₂-NH₂ ou -CH₂-SH ou comprend ces groupes fonctionnels en quantités inférieures à 1 groupe fonctionnel pour 1 000 atomes de chaîne principale du ligand de surface polymère ; de préférence dans laquelle le polymère a la chaîne principale définie pour le ligand de surface dans la revendication 5 ou 6 mais est dépourvu de L, ou de préférence dans laquelle le polymère est sélectionné parmi le poly(méthacrylate de méthyle) (PMMA), le polydiméthylsiloxane (PDMS), le polystyrène (PS), le polyéthylène téréphtalate (PET).

9. Méthode de génération d'une composition selon l'une des revendications précédentes, comprenant la fourniture de cristaux luminescents de pérovskite et la fourniture d'un ligand de surface polymère avec un poids moléculaire d'au moins 700 g/mol, dans laquelle le ligand de surface polymère est un polysiloxane comprenant une chaîne principale et des chaînes latérales, dans laquelle au moins une chaîne latérale comprend au moins un groupe fonctionnel sélectionné parmi les amines, les carboxylates, les phosphates, les thiols ou leurs combinaisons, et le mélange desdits cristaux luminescents de pérovskite avec le ligand de surface polymère et/ou la cristallisation des cristaux luminescents de pérovskite en présence du ligand de surface polymère, formant ainsi un complexe cristal luminescent de pérovskite-ligand de surface.

10. La méthode selon la revendication 9, comprenant la génération des cristaux luminescents de pérovskite en présence du ligand de surface polymère, dans laquelle les cristaux luminescents de pérovskite sont sélectionnés parmi les composés de formule AₐM_{b}X_{c}, dans laquelle
A représente un ou plusieurs cations monovalents sélectionnés parmi Cs⁺, Rb⁺, K⁺, Na⁺, Li⁺, ammonium, méthylammonium, formamidinium, strontium, guanidinium, imidazolium, pyridinium, pyrrolidinium, thiourée protonée, ou un mélange de ceux-ci ;
M représente un ou plusieurs métaux sélectionnés dans le groupe comprenant Pb²⁺, Ge²⁺, Sb²⁺, Te²⁺, Sn²⁺, Bi³⁺, Mn²⁺, Cu²⁺, et tous les ions de terres rares, de préférence Ce²⁺, Tb²⁺, Eu²⁺, Sm²⁺, Yb²⁺, Dy²⁺, Tm²⁺ ; et Ag⁺ ou Au⁺ ou un mélange de ceux-ci ;
X représente un ou plusieurs anions sélectionnés dans le groupe comprenant F⁻, Cl⁻, Br⁻, I⁻, cyanure, thiocyanate, ou un mélange de ceux-ci ;
a est un entier de 1 à 4 ;
b est un entier de 1 ou 2 ;
c est un entier de 3 à 9 ;
de préférence de formule AMX₃, formule A₄MX₆ ou des mélanges de celles-ci.

11. La méthode selon la revendication 9 ou 10, comprenant en outre le mélange d'un polymère, de préférence un élastomère, avec le complexe cristal luminescent de pérovskite-ligand de surface, ou la formation d'un polymère autour du complexe cristal luminescent de pérovskite-ligand de surface pour incorporer le complexe cristal luminescent de pérovskite-ligand de surface dans le polymère.

12. Méthode de remplacement partiel des anions dans une composition de cristaux luminescents de pérovskite selon la revendication 3, comprenant l'étape de mise en contact des cristaux luminescents de pérovskite avec un ligand de surface polymère comprenant un cation ammonium, de préférence un cation ammonium primaire, lié ioniquement à un anion, de préférence un anion différent de l'anion à remplacer, dans un fluide, dans laquelle le ligand de surface polymère est le ligand de surface polymère selon l'une des revendications 1 à 7, à l'exception qu'il comprend le cation ammonium lié ioniquement à un anion au lieu des groupes fonctionnels sélectionnés.

13. Utilisation de la composition de cristaux luminescents de pérovskite selon l'une des revendications 1 à 8 comme composant générateur de couleur, de préférence dans un écran ou comme matériau absorbeur de particules chargées ou matériau absorbeur de photons, de préférence pour absorber les photons UV et de haute énergie tels que les photons de rayons X et de rayons gamma ou les particules chargées, ou comme matériau scintillateur.

14. Dispositif de détection de rayonnement comprenant une composition de cristaux luminescents de pérovskite selon l'une des revendications 1 à 8, une source d'excitation et un système de détection fonctionnellement connecté à la composition de cristaux luminescents de pérovskite, de préférence dans lequel la source d'excitation comprend une source qui produit des particules chargées à haute énergie ou des photons à haute énergie avec une longueur d'onde inférieure à 600 nm, de préférence inférieure à 480 nm, et/ou de préférence dans lequel le système de détection comprend une caméra numérique, un détecteur à tube photomultiplicateur (PMT), un transistor à couches minces (TFT), un capteur à photodiode, un capteur CCD, un capteur à semi-conducteur à oxyde métallique complémentaire (CMOS) ou un capteur TFT à oxyde d'indium gallium zinc (IGZO), particulièrement de préférence une caméra numérique.

15. Cellule d'affichage émettrice de lumière comprenant une source lumineuse, de préférence une source émettrice de lumière bleue ou une source lumineuse à pompage électrique, et un film polymère, dans laquelle le film polymère comprend au moins deux zones, dans laquelle une première zone est transparente à la lumière de la source lumineuse et une deuxième zone comprend une composition de cristaux luminescents de pérovskite selon l'une des revendications 1 à 8 dans le film polymère,
